# EUROPÄISCHE PATENTSCHRIFT

(11) **EP 1 958 268 B1**
(45) Veröffentlichungstag und Bekanntmachung des Hinweises auf die Patenterteilung: **19.10.2011**
(21) Anmeldenummer: 06818050.4
(22) Anmeldetag: 06.11.2006
(51) Int. Cl.: H01L 33/00, H01L 31/0232

(54) **VERBUND-BAUTEIL MIT EINEM OPTISCHEN ELEMENT**
COMPOSITE COMPONENT PROVIDED WITH AN OPTICAL ELEMENT
COMPOSANT COMPOSITE DOTE D'UN ELEMENT OPTIQUE

(30) Priorität: 09.12.2005 DE 102005058902; 08.03.2006 DE 102006010729
(43) Veröffentlichungstag der Anmeldung: 20.08.2008
(73) Patentinhaber: OSRAM Opto Semiconductors GmbH, 93055 Regensburg (DE)
(72) Erfinder: BRAUNE, Bert, 93173 Wenzenbach (DE); BLÜMEL, Simon, 84069 Schierling (DE); WOLF, Manfred, 94356 Kirchroth (DE)
(74) Vertreter: Epping - Hermann - Fischer
(86) Internationale Anmeldenummer: PCT/DE2006/001947
(87) Internationale Veröffentlichungsnummer: WO 2007/076737

(56) Entgegenhaltungen:
- EP-A- 1 408 087
- WO-A-2004/068447
- WO-A-2005/064626
- DE-A1- 10 214 119
- JP-A- 57 072 108
- JP-A- 60 175 225
- US-A- 5 444 520
- US-A- 6 165 393
- US-A1- 2005 107 118
- US-A1- 2005 179 805
- US-B1- 6 527 411

## Beschreibung

Die vorliegende Erfindung betrifft ein Verbund-Bauteil mit einem optischen Element.

In der Druckschrift US 2005/0107118 A1 ist ein Mobiltelefon mit einer Kamera angegeben.

Die Druckschrift EP 1 408 087 B1 betrifft eine Harzkomposition und ein Festkörperbauteil, das damit eingekapselt ist, sowie eine Herstellungsmethode hierfür.

Eine Herstellungsmethode für eine dielektrische Linse ist in der Druckschrift US 6,165,393 A offenbart.

Weiterhin ist in der Druckschrift JP 57-072108 A eine gegossene Linse beschrieben.

In der Druckschrift US 2005/0179805 A1 ist ein optisches System sowie eine Justagemethode hierfür offenbart.

Die Druckschrift WO 2004/068447 A1 bezieht sich auf ein Optikelement für ein Wechselverkehrszeichen.

Ein optoelektronisches Modul sowie ein Verfahren zu dessen Herstellung finden sich in der Druckschrift WO 2005/064626 A2.

Ein optoelektronisches Bauelement ist in der Druckschrift DE 102 14 119 A1 angegeben.

Eine Aufgabe der vorliegenden Erfindung ist es, ein mechanisch stabilisiertes und zuverlässig strahlformendes optisches Element, insbesondere ein miniaturisiertes optisches Element anzugeben. Weiterhin sollen ein Verfahren zur Herstellung eines derartigen optischen Elements und ein Verbund-Bauteil mit dem optischen Element angegeben werden.

Diese Aufgabe wird durch ein Verbund-Bauteil mit den Merkmalen des Patentanspruchs 1 gelöst. Vorteilhafte Weiterbildungen und Ausgestaltungen sind Gegenstand der abhängigen Patentansprüche.

Gemäß zumindest einer Ausführungsform ist ein optische Element für ein optoelektronisches Bauelement geeignet. Insbesondere ist das optische Element bevorzugt zur Befestigung an einem optoelektronischen Bauelement ausgebildet. Optoelektronische Bauelemente weisen in der Regel vergleichsweise kleine Abmessungen auf, so dass ein an einem optoelektronischen Bauelement zu befestigendes optisches Element auf das Bauelement abgestimmt und insbesondere bevorzugt miniaturisiert zu fertigen ist. Das optoelektronische Bauelement weist bevorzugt einen optoelektronischen Halbleiterchip auf, der besonders bevorzugt zur Strahlungserzeugung und/oder zum Strahlungsempfang ausgebildet ist.

Das Strahlformungsteil ist zweckmäßigerweise auf die gewünschten Strahlformungseigenschaften des optischen Elements abgestimmt. Insbesondere kann die Abstrahlcharakteristik eines Verbund-Bauteils mit dem optoelektronischen Bauelement und dem optischen Element mittels des Strahlformungsteils gemäß einer vorgegebenen Abstrahlcharakteristik geformt sein.

Mittels des Trägerteils wird das Strahlformungsteil bevorzugt mechanisch stabilisiert und/oder das Trägerteil ist zur Befestigung des optischen Elements mittels des Trägerteils am optoelektronischen Bauelement ausgebildet. Insbesondere ist das optische Element bevorzugt mittels des Trägerteils am optoelektronischen Bauelement befestigbar oder befestigt. Das Trägerteil dient bevorzugt nicht der Strahlformung sondern ist auf mechanische Eigenschaften und nicht auf optische Eigenschaften hin optimiert.

Gemäß zumindest einer Ausführungsform ist das Strahlformungsteil an das Trägerteil angeformt . Das Trägerteil und das Strahlformungsteil sind demnach bevorzugt nacheinander geformt. Diese Teile können daher vereinfacht auf verschiedene Funktionen hin optimiert ausgebildet sein. Das Trägerteil ist bevorzugt auf mechanische Stabilität, insbesondere Temperaturstabilität und/oder Festigkeit, hin optimiert. Das Strahlformungsteil ist bevorzugt hinsichtlich der Strahlungsformungseigenschaften und/oder Strahlungsstabilität, insbesondere gegenüber kurzwelliger, etwa ultravioletter oder blauer, hochenergetischer Strahlung ausgebildet. Ein strahlungsstabiles Strahlformungsteil ändert mit vorteil die optischen Eigenschaften - selbst bei Bestrahlung mit hochenergetischer Strahlung über einen maßgeblichen Zeitraum - nicht wesentlich. Strahlungsbedingte Trübungen oder Verformungen des Strahlformungsteils können so gemindert werden.

Gemäß zumindest einer Ausführungsform enthalten das Strahlformungsteil und das Trägerteil voneinander verschiedene Materialien. Zweckmäßigerweise werden hierbei für die jeweilige Funktion des Trägerteils beziehungsweise des Strahlformungsteils optimierte Materialien eingesetzt. Da das Trägerteil und das Strahlformungsteil aneinander angeformt sein können, sind die Freiheitsgrade bei der Auswahl der Materialien mit Vorteil erhöht. So kann zum Beispiel das Trägerteil strahlungsundurchlässig, zum Beispiel aus einem Material, das für eine vom optoelektronischen Bauelement zu empfangende und/oder zu emittierende Strahlung strahlungsundurchlässig ist, ausgebildet sein.

Auf diese Weise kann ein miniaturisiertes optisches Element für ein optoelektronisches Bauelement vereinfacht zugleich mechanisch stabil und zuverlässig beständig strahlformend ausgebildet werden. Ferner kann das Trägerteil das Strahlformungsteil mechanisch stabilisieren. Dies ist von besonderem Vorteil, falls das Strahlformungsteil aus einem flexiblen, leicht bieg- oder dehnbarem Material gebildet ist. Das Trägerteil ist zweckmäßigerweise gegenüber dem Strahlformungsteil in diesem Falle mit größerem Kraftaufwand verformbar, insbesondere bieg- oder dehnbar, ausgebildet.

Gemäß zumindest einer Ausführungsform sind das Trägerteil und das Strahlformungsteil mechanisch stabil miteinander verbünden. Insbesondere kann zwischen diesen Teilen eine innige mechanische Verbindung ausgebildet sein. Auf zusätzliche Haftvermittler, etwa einen Kleber, zur Befestigung des Trägerteils und des Strahlformungsteils aneinander, kann verzichtet werden. Vielmehr können das Strahlformungsteil und das Trägerteil derart aneinander angeformt sein, dass sich während des Anformens eine mechanisch stabile Verbindung ausbildet.

Gemäß zumindest einer Ausführungsform sind das Strahlformungsteil und das Trägerteil aus voneinander verschiedenen Grundmaterialien, insbesondere Grundformmassen, ausgebildet. Die Grundmaterialien können gegebenenfalls in geringen Mengen gleiche Zusatzstoffe enthalten. Bevorzugt weisen die Grundmaterialien jedoch unterschiedliche Hauptbestandteile auf, die die zweckmäßigerweise verschiedenen physikalischen Eigenschaften des Trägerteils beziehungsweise des Strahlformungsteils bestimmen.

Gemäß zumindest einer Ausführungsform enthalten das Trägerteil und das Strahlformungsteil verschiedene Kunststoffe. Kunststoffe sind gegenüber einem optischen Element, das beispielsweise Glas enthält, vergleichsweise kostengünstig und vereinfacht verarbeitbar.

Gemäß zumindest einer Ausführungsform enthält das Trägerteil einen Thermoplasten oder einen Duroplasten. Derartige Materialien zeichnen sich durch eine vorteilhaft hohe mechanische Stabilität aus. Für ein temperaturstabiles Trägerteil verfügbare Thermoplasten beziehungsweise Duroplasten sind aber in der Regel strahlungsundurchlässig, insbesondere vom infraroten über den sichtbaren bis in den ultravioletten Spektralbereich, so dass sie zur Strahlformung daher im Wesentlichen ungeeignet sind. Als temperaturstabil ist im Zweifel ein Material anzusehen, das bei Temperaturen größer oder gleich 250 °C, bevorzugt über einen Zeitraum von 10 s oder mehr, etwa bis zu 20 s, im Wesentlichen formstabil ist. Bevorzugt ist das Material gegenüber einer Temperaturrampe, die bis zu 250 °C oder bis zu 260 °C in einem Zeitraum von 100s oder mehr, insbesondere bis zu 120s, gefahren wird, im Wesentlichen formstabil. Besonders bevorzugt ist das Material bei Temperaturen größer oder gleich 250 °C über einen Zeitraum von 100 s oder mehr, etwa bis zu 120 s, im Wesentlichen formstabil.

Gemäß zumindest einer Ausführungsform enthält das Strahlformungsteil ein Silikon-Hybridmaterial. Derartige Materialien sind zur Strahlformung besonders geeignet und sind insbesondere hinsichtlich der optischen Eigenschaften beständig gegenüber dauerhafter Einwirkung kurzwelliger, etwa ultravioletter oder blauer Strahlung. Derartige Materialen enthaltende Teile zur Strahlformung sind jedoch vergleichsweise leicht biegbar und flexibel, so dass sie zur, insbesondere lagestabilen, Befestigung des optischen Elements an einem optoelektronischen Bauteil nur bedingt geeignet sind. Bei Hybrid-Materialien, das heißt Materialien, die voneinander verschiedene Komponenten aufweisen, können durch die Wahl der Komponenten die mechanischen Eigenschaften bedingt beeinflusst werden.

Silikon-Hybridmaterialien, etwa ein Silikon und ein Reaktionsharz, zum Beispiel ein Epoxidharz, enthaltend, weisen gegenüber einem ein nicht-hybridisiertes .Silikon enthaltenden Formteil in der Regel ein höheres Haftvermögen auf. Ein Silikon-Hybridmaterial ist aufgrund der erhöhten Haftung vereinfacht an ein anderes Element, z. B. das Trägerteil, unter Ausbildung einer mechanisch besonders stabilen Anbindung anformbar. Die chemischen Hafteigenschaften eines Hybrides können insbesondere denen eines Epoxidmaterials, z. B. eines Epoxidharzes ähneln. Ein Silikonmaterial ist gegenüber einem Hybridmaterial, auch einem Silikon-Hybridmaterial, jedoch in der Regel kostengünstiger.

In wenigstens einer Ausführungsform des Verfahrens zur Herstellung eines optischen Elements, das ein Trägerteil und ein Strahlformungsteil aufweist, wird zunächst ein Formkörper für das Trägerteil oder das Strahlformungsteil geformt und/oder hergestellt. Der Formkörper wird bevorzugt mittels Gießen, insbesondere Spritzgießen, hergestellt. Hierzu kann eine Formmasse für den Formkörper in eine geeignete Form, insbesondere eine Spritzgießform, eingefüllt, insbesondere eingespritzt, werden. Vorzugsweise wird eine Kunststoff-Formmasse eingesetzt. Weiterhin wird die Formmasse bevorzugt nachfolgend an- oder ausgehärtet oder anderweitig verfestigt und so ein Formkörper hergestellt.

Daraufhin wird ein weiterer Formkörper für das Strahlformungsteil beziehungsweise das Trägerteil an den zuerst hergestellten Formkörper angeformt. Bevorzugt wird eine Formmasse für den weiteren Formkörper an den zuerst hergestellten Formkörper angegossen, insbesondere angespritzt. Eine von der zuvor verwendeten Formmasse verschiedene Formmasse, insbesondere eine Kunststoff-Formmasse ist hierfür besonders geeignet.

Demnach wird das optische Element bevorzugt mittels eines Mehrkomponenten-Gussverfahrens, in dem, gegebenenfalls verschiedenen Formmassen zeitlich voneinander getrennt für einen Verbund-Formkörper verarbeitet werden, hergestellt. Das Anformen verschiedener Formmassen aneinander, wird so erleichtert. Bevorzugt ist das Gussverfahren ein Zweikomponenten-Spritzgussverfahren (2K-Spritzguss).

Ein derartiges Gussverfahren, insbesondere ein Spritzgussverfahren, ist zur industriellen Fertigung von miniaturisierten optischen Elementen, deren jeweilige Trägerteile und Strahlformungsteile auf verschiedene Funktionen hin optimiert sind, in hohen Stückzahlen besonders geeignet.

Gemäß wenigstens einer Ausführungsform des Verfahrens werden die beiden Formkörper in einer gemeinsamen Form, insbesondere einer Gussform, zum Beispiel einer Spritzgießform, hergestellt. Eine entsprechende Form kann hierzu zunächst mit einer Formmasse für den einen Formkörper teilbefüllt werden. Eine weitere Formmasse für den anderen Formkörper kann nachfolgend unter Anformung an die zuerst eingefüllte Formmasse in die gemeinsame Form eingefüllt werden. Bevorzugt wird die zuerst eingefüllte Formmasse vor dem Einfüllen der weiteren Formmasse an- oder ausgehärtet, so dass ein Anformen der weiteren Formmasse an den mittels der zuerst eingefüllten Formmasse ausgebildeten oder auszubildenden Formkörper erleichtert wird.

Gemäß wenigstens einer weiteren Ausführungsform des Verfahrens wird der zuerst hergestellte Formkörper für das Anformen des weiteren Formkörpers aus der entsprechenden Form entformt und in eine weitere Form, insbesondere eine Gussform, zum Beispiel eine Spritzgießform, für den weiteren Formkörper umgelegt. Hierzu wird der zuerst hergestellte Formkörper, vorzugsweise in der ersten Form, zweckmäßigerweise zunächst an- oder ausgehärtet, so dass die Gefahr einer Verformung dieses Formkörpers beim Umlegen verringert wird.

Der weitere Formkörper kann auf den zuerst hergestellten Formkörper aufgeformt, insbesondere aufgegossen und/oder aufgespritzt, werden.

Gemäß zumindest einer weiteren Ausführungsform des Verfahrens wird das Strahlformungsteil an das Trägerteil angeformt und nicht umgekehrt. Das Ausbilden einer mechanisch stabilen Verbindung zwischen dem Strahlformungsteil und dem Trägerteil wird so erleichtert, da das, vorzugsweise ausgehärtete, Trägerteil hierbei vereinfacht eine Festigkeit aufweisenkann, die eine mechanisch stabil ausgebildete mechanische Verbindung fördert.

Gemäß zumindest einer Ausführungsform des Verfahrens wird eine an das, vorzugsweise ausgehärtete, Trägerteil angeformte Formmasse für das Strahlförmungsteil nach dem Anformen an- oder ausgehärtet, wobei die Formmasse beim Härten derart auf das Trägerteil aufschrumpft, dass sich nach dem Härten eine mechanisch stabile Verbindung zwischen dem Trägerteil und dem Strahlformungsteil ausbildet. Das Strahlformungsteil kann nach dem Härten insbesondere unter Zugspannung stehen. Die mechanische Stabilität des Strahlformungsteils gegenüber einer Verformung bei mechanischer Belastung des Strahlformungsteils wird so erhöht.

Nach dem Anformen des weiteren Formkörpers an den zuerst geformten Formkörper und gegebenenfalls anschließendem An- oder Aushärten kann das optische Element entformt werden.

Das beschriebene Verfahren eignet sich-besonders zur Herstellung optischer Elemente für optoelektronische Bauteile, da mittels des Verfahrens speziell auf optoelektronische Bauteile abgestimmte optische Elemente in hohen Stückzahlen und geringer Baugröße zuverlässig gefertigt werden können. Die weiter oben und im Folgenden für das optische Element bzw. das optoelektronische Bauelement beschriebenen Merkmale können demnach auch für das Verfahren herangezogen werden und umgekehrt.

Gemäß zumindest einer weiteren Ausführungsform weist das optische Element ein Verbindungselement oder eine Mehrzahl von Verbindungselementen auf, die am oder im Trägerteil ausgebildet sind, wobei das Strahlformungsteil das Verbindungselement beziehungsweise die Verbindungselemente zumindest teilweise umformt, in das Verbindungselement beziehungsweise die Verbindungselemente eingeformt ist und/oder durch das Verbindungselement beziehungsweise die Verbindungselemente durchgeformt ist.

Bevorzugt ist das Verbindungselement beziehungsweise sind die Verbindungselemente als Erhebung, Vertiefung oder Aussparung ausgebildet.

Eine Erhebung ist zum Umformen besonders geeignet. Durch das Umformen einer Erhebung vergrößert sich die Kontaktfläche zwischen dem Strahlformungsteil und dem Trägerteil, wodurch die Stabilität der mechanischen Verbindung gefördert wird. Eine Vertiefung eignet sich besonders für das Einformen. Hierdurch wird ebenfalls die Kontaktfläche zwischen dem Strahlformungsteil und dem Trägerteil vergrößert. Eine Aussparung ist für das Durchformen besonders geeignet. Besonders bevorzugt erstreckt sich das durch die Aussparung geformte Material des Strahlformungsteils, insbesondere vollständig, durch die Aussparung und das Trägerteil hindurch und weist auf zwei Seiten der Aussparung bevorzugt eine laterale Ausdehnung auf, die größer als die der Aussparung ist. Hierdurch kann sich, insbesondere auf einer einer strahlformenden Oberfläche des Strahlformungsteils abgewandten Seite des Trägerteils, eine nietenartige, mechanisch besonders stabile Verbindung zwischen dem Trägerteil und dem Strahlformungsteil ausbilden. Die Erhebung, die Vertiefung und/oder die Aussparung können gegebenenfalls hinterschnitten sein. Die Stabilität der Verbindung kann so weitergehend erhöht werden.

Gemäß zumindest einer weiteren Ausführungsform ist das Trägerteil rahmenartig ausgeführt. Im Trägerteil ist dann insbesondere eine, vorzugsweise zentral angeordnete, Apertur, in der der Trägerrahmen ausgespart ist, für den Strahlungsdurchtritt ausgebildet. Das Einsetzen eines strahlungsundurchlässigen Materials für das Trägerteil wird so erleichtert, ohne die Strahlformung am Strahlformungsteil oder den Strahlungsein- oder -austritt für das optoelektronische Bauelement zu beeinträchtigen. Das Strahlformungsteil überdeckt die Apertur des Trägerrahmens bevorzugt, insbesondere vollständig, in lateraler Richtung.

Das Strahlformungsteil kann die Apertur insbesondere überspannen. Hierdurch wird der Strahlungsdurchtritt durch das Trägerteil und eine effiziente, großflächige Strahlformung am optischen Element vereinfacht erreicht.

In einer weiteren bevorzugten Ausgestaltung ist das Strahlformungsteil linsenartig ausgeführt.

Gemäß einer weiteren Ausführungsform weist eine Oberfläche des Strahlformungsteils einen konkav gekrümmten Teilbereich und einen konvex gekrümmten Teilbereich auf. Bevorzugt umgibt der konvex gekrümmte Teilbereich den konkav gekrümmten Teilbereich in lateraler Richtung. Besonders.bevorzugt umläuft der konvex gekrümmte Teilbereich den konkav gekrümmten Teilbereich lateral, insbesondere vollständig. Das optische Element kann insbesondere derart ausgeführt sein, dass eine Strahlformung, insbesondere mittels Brechung, im Wesentlichen nur an der Oberfläche des Strahlungsformungsteils mit den gekrümmten Teilbereichen erfolgt. Die Strahlformung kann so besonders zuverlässig erfolgen. Besonders bevorzugt ist die Oberfläche mit den gekrümmten Teilbereichen auf einer dem optoelektronischen Bauelement abgewandten Seite des Strahlformungsteils ausgebildet. Ferner verläuft eine optische Achse des an dem optoelektronischen Bauelement befestigten optischen Elements bevorzugt durch den konkav gekrümmten Teilbereich und/oder den optoelektronischen Halbleiterchip der optoelektronischen Bauelements. Die optische Achse kann insbesondere im Wesentlichen senkrecht zu einer dem Strahlformungsteil zugewandten Oberfläche des optoelektronischen Halbleiterchips verlaufen. Die Oberfläche mit den gekrümmten Teilbereichen ist bevorzugt rotationssymmetrisch zur optischen Achse ausgeführt.

Für ein optoelektronisches Bauelement kann mittels einer derartigen Formgebung vereinfacht eine homogene, breitwinklige Abstrahl- oder Empfangscharakteristik des Bauelements schräg zur optischen Achse erreicht werden. Ein Maximum der abgestrahlten Strahlungsleistung kann z.B. bei einem vergleichsweise großen Winkel zur optischen Achse, insbesondere größer als 60°, liegen. Hierdurch wird eine homogene Ausleuchtung einer, insbesondere senkrecht zur optischen Achse verlaufenden, zu beleuchtenden Fläche bei geringem Abstand zum Halbleiterchip erleichtert. Ferner kann mittels einer derartigen Formgebung des Strahlformungsteils eine besonders homogene örtliche Bestrahlungsstärkeverteilung - Watt der auf die Fläche treffenden.Strahlungsleistung bezogen auf den inhalt der beleuchteten Fläche in m² - auf der zu beleuchtenden Fläche erzielt werden. Mittels des konkav und des konvex gekrümmten Teilbereichs kann die Strahlung im Wesentlichen von der optischen Achse weggebrochen werden, wodurch der auf der zu beleuchtenden Fläche beleuchtete Bereich vergrößert werden kann. Das optoelektronische Bauelement mit dem befestigten optischen Element kann so als Verbund-Bauteil bei einer zu beleuchtenden Teilfläche einer vorgegebenen Größe vereinfacht näher an der zu beleuchtenden, vorzugsweise ebenen, Fläche angeordnet werden und ist somit für das Ausbilden einer kompakten Beleuchtungsvorrichtung besonders geeignet.

Das optoelektronische Bauelement mit dem befestigen optischen Element eignet sich damit besonders zur Hinterleuchtung für eine kompakt auszubildende Anzeigevorrichtung, insbesondere eine Flüssigkristallanzeigevorrichtung (LCD: Liquid Crystal Display). Zweckmäßigerweise ist das optoelektronische Bauelement in diesem Falle zur Erzeugung sichtbaren Lichts ausgeführt.

Das am optoelektronischen Bauelement montierte optische Element ist bevorzugt derart ausgebildet, dass der Verbund mit dem optoelektronischen Bauelement und dem optischen Element als Verbund-Bauteil mittels Lötmontage, zum Beispiel auf einer Leiterplatte, montierbar ist. Beim Löten werden die optischen Eigenschaften des Strahlformungsteils, zum Beispiel die Transmission oder die Strahlformungseigenschaften, und die mechanische Stabilität des Trägerteils und hierüber insbesondere die Stabilität der Befestigung am optoelektronischen Bauteil nicht maßgeblich beeinträchtigt. Durch den Einsatz verschiedener Materialien für das Trägerteil und das Strahlformungsteil des optischen Elements ist eine zuverlässige Lötbarkeit des Verbund-Bauteils ohne wesentliche Beschädigung vereinfacht erzielbar

Das Verbund-Bauteil kann insbesondere in bleifreier Lötmontage unter Verwendung eines bleifreien Lots montiert werden. Bei den hierfür in der Regel erforderlichen Löttemperaturen von 250 °C oder größer und insbesondere bis zu 260 °C, bei einer Lötdauer von 100 s oder mehr, insbesondere bis zu 120 s ist das optische Element mit Vorteil stabil. Die maximale Löttemperatur, z.B. 250 °C bis 260 °C, wird hierbei in der Regel über eine Temperaturrampe, z.B. mit einer Dauer zwischen 100 s und 120 s, erreicht, wobei die Maximaltemperatur bevorzugt 10 s oder mehr, insbesondere bis zu 20 s gehalten wird.

Bei der Lötmontage ist das Trägerteil bevorzugt stabil gegenüber Verformungen und das Strahlformungsteil ist bevorzugt stabil gegenüber Verformungen und insbesondere gegenüber einer Degradierung der optischen Eigenschaften. Hierbei ist ein Thermoplast oder ein Duroplast für das Trägerteil und ein Silikon oder ein Silikon-Hybridmaterial für das Strahlformungsteil besonders geeignet. Ein optisches Element, bei dem verschiedene Materialien für das Trägerteil und das Strahlformungsteil eingesetzt werden, erleichtert das Ausbilden eines zuverlässig bleifrei lötbaren Verbund-Bauteils mit dem optischen Element und dem optoelektronischen Bauelement.

Gemäß zumindest einer Ausführungsform ist das optoelektronische Bauelement als oberflächenmontierbares Bauelement ausgebildet. Die Oberflächenmontagetechnik erleichtert die Montage des optoelektronischen Bauelements und insbesondere die Montage einer Mehrzahl dicht gepackter optoelektronischer Bauelemente auf einem Trägerelement, z.B. einer Leiterplatte. Bevorzugt ist das optoelektronische Bauelement.als LED-Bauelement ausgeführt.

Gemäß zumindest einer weiteren Ausführungsform ist das optische Element als Aufsatzoptik, insbesondere als Überstülpoptik oder Aufsteckoptik, zum Aufsetzen, insbesondere Überstülpen oder Aufstecken, auf ein optoelektronisches Bauelement ausgebildet.

Unter einer Aufsteckoptik ist hierbei ein optisches Element zu verstehen, das in Montagevorrichtungen des optoelektronischen Bauteils eingreift und hierzu vorzugsweise geeignete Befestigungselemente aufweist:

Eine Überstülpoptik kann eingriffsfrei und/oder rastverbindungsfrei am optoelektronischen Bauelement befestigt werden. Insbesondere sind bei einer Überstülpoptik spezielle Elemente zur Befestigung, etwa das Ausbilden von Montagevorrichtungen im optoelektronischen Bauelement, nicht erforderlich.

Gemäß zumindest einer weiteren Ausführungsform weist das optoelektronische Bauelement einen Gehäusekörper mit einer Strahlungsdurchtrittsfläche auf, wobei das optische Element bevorzugt am Gehäusekörper befestigbar oder befestigt ist. Vorzugsweise ist das optische Element mittels des Trägerteils am Gehäusekörper befestigt.

Der Gehäusekörper schützt den Halbleiterchip des Bauelements mit Vorteil vor schädlichen äußeren Einflüssen und vor mechanischen Belastungen. Der Halbleiterchip kann beispielsweise in einer Kavität des Gehäusekörpers angeordnet und gegebenenfalls mit elektrischen Anschlussleitern des Bauelements elektrisch leitend verbunden sein. Der Gehäusekörper ist bevorzugt als vorgeformter Gehäusekörper ausgeführt, auf den der Halbleiterchip montiert und mit den Anschlussleitern elektrisch leitend verbunden wird. Ferner ist der Halbleiterchip bevorzugt in eine, vorzugsweise in der Kavität angeordnete Umhüllung, zum Beispiel ein Silikon oder ein Silikon-Hybridmaterial enthaltend, eingebettet. Die Umhüllung schützt den Halbleiterchip mit Vorteil vor äußeren schädlichen Einflüssen, etwa Feuchtigkeit.

Gemäß zumindest einer weiteren Ausführungsform enthalten das Trägerteil und der Gehäusekörper Materialien, die hinsichtlich der thermischen Ausdehnungskoeffizienten aneinander angepasst sind. Hierzu weichen die thermischen Ausdehnungskoeffizienten des Trägerteils und des Gehäusekörpers bevorzugt um 10 % oder weniger, besonders bevorzugt 5 % oder weniger, voneinander ab. Die Gefahr einer Verringerung der Stabilität der Befestigung des optischen Elements am Gehäusekörper bei hohen Temperaturen, wie etwa beim Löten, wird durch die Anpassung der thermischen Ausdehnungskoeffizienten erheblich verringert. Über derartige Anpassung der Ausdehnungskoeffizienten werden mechanische Spannungen zwischen dem optischen Element und dem optoelektronischen Bauelement bei Temperaturschwankungen verringert bzw. weitgehend vermieden. Daher wird eine erhöhte Gesamtstabilität eines Verbund-Bauteils erzielt. Bevorzugt enthalten das Trägerteil und der Gehäusekörper ein gleiches Material, insbesondere eine gleiche Grundformmasse, oder eine entsprechende oder eine gleiche Materialzusammensetzung.

Gemäß einer weiteren Ausführungsform ist am oder im Trägerteil ein oder eine Mehrzahl von Befestigungselementen ausgebildet, wobei das optoelektronische Bauelement, insbesondere der Gehäusekörper, eine oder eine Mehrzahl von zu den Befestigungselementen korrespondierenden Montagevorrichtungen aufweist, in die die Befestigungselemente für die Befestigung des optischen Elements am optoelektronischen Bauelement eingreifen. Die Befestigungselemente sind bevorzugt am Trägerteil ausgeformt. Insbesondere kann das Trägerteil als einstückiges Formteil ausgeführt sein. Die Montagevorrichtungen des optoelektronisches Bauelements können beispielsweise als Ausnehmungen oder Aussparungen im Gehäusekörper, in die, etwa stiftartige, Befestigungselemente des optischen Elements eingreifen können, ausgeführt sein. Über die Befestigungselemente kann das auf das Bauelement aufgesteckte optische Element beispielsweise mittels einer Klebeverbindung, Presspassung, Heißpresspassung, thermischem Nieten, Verstemmen oder Heißverstemmen am optoelektronischen Bauteil befestigt werden. Für eine derartige Befestigung sind jedoch eigens ausgebildete Montagevorrichtungen am Bauelement in der Regel erforderlich.

Gemäß zumindest einer weiteren Ausführungsform übergreift das Trägerteil den Gehäusekörper. Das optische Element kann demnach insbesondere über den Gehäusekörper überstülpbar sein oder über diesen gestülpt sein. Das Trägerteil kann den Gehäusekörper, weiterhin, insbesondere vollständig, lateral umlaufen. Eine Befestigung des optischen Elements am Bauelement mittels des Trägerteils kann so vorteilhaft großflächig ausgeführt werden. Insbesondere kann der Gehäusekörper innerhalb des Trägerrahmens angeordnet sein. Weiterhin ist das optische Element bevorzugt derart ausgeführt, dass der Gehäusekörper in das optische Element einlegbar ist. Mittels derartiger Ausführungen des optischen Elements kann eine besonders einfache, insbesondere rasterfreie und/oder eingriffsfreie, Befestigung des optischen Elements, insbesondere direkt am optoelektronischen Bauelement ausgebildet werden. Auf vergleichsweise aufwendige Montagevorrichtungen, etwa für eine Steckverbindung, am optoelektronischen Bauelement kann so verzichtet werden.

Gemäß zumindest einer weiteren Ausführungsform ist das Trägerteil auf der dem optoelektronischen Bauelement zugewandten Seite des optischen Elements angeordnet oder ausgebildet.

Gemäß zumindest einer weiteren Ausführungsform ist das optische Element an dem optoelektronischen Bauelement, insbesondere ausschließlich, mittels eines Haftvermittlers befestigt. Auf im optischen Element extra ausgeformte Befestigungselemente im obigen Sinne kann so verzichtet werden.

Gemäß zumindest einer weiteren Ausführungsform ist das optische Element von außerhalb des Gehäusekörpers an einer den Gehäusekörper lateral begrenzenden, insbesondere äußersten, Seitenfläche des Gehäusekörpers befestigbar oder befestigt. Der Haftvermittler ist hierbei bevorzugt zwischen dem Trägerteil und der Seitenfläche des Gehäusekörpers angeordnet und besonders bevorzugt mit dem Trägerteil und der Seitenfläche in direktem Kontakt. Insbesondere kann der Haftvermittler auf gegenüberliegenden Seitenflächen des Gehäusekörpers zwischen dem Trägerteil und dem Gehäusekörper angeordnet sein. Der Haftvermittler kann ferner an allen Seitenflächen des Gehäusekörpers angeordnet sein oder den Gehäusekörper umlaufen.

Gemäß zumindest einer weiteren Ausführungsform ist der Haftvermittler zwischen dem Strahlformungsteil und dem optoelektronischen Bauelement angeordnet. Die zur Befestigung des optischen Elements zur Verfügung stehende Fläche kann so vorteilhaft vergrößert werden Hierdurch wird die mechanische Stabilität der Befestigung erhöht.

Gemäß zumindest einer weiteren Ausführungsform erstreckt sich der Haftvermittler, insbesondere schichtartig, entlang einer dem Strahlformungsteil zugewandten Oberfläche des Gehäusekörpers und von dieser Oberfläche ausgehend bis zur und entlang einer Seitenfläche des Gehäusekörpers. Durch eine derartige Haftvermittlungsschicht kann auch in einem Randbereich der dem Strahlformungsteil zugewandten Oberfläche des Gehäusekörpers und im Bereich der Seitenfläche durch Umformung des Randes eine mechanisch stabile Verbindung ausgebildet werden.

Gemäß zumindest einer weiteren Ausführungsform erstreckt sich der Haftvermittler von der Strahlungsdurchtrittsfläche des Gehäusekörpers ausgehend, insbesondere durchgehend bis zur und entlang der Seitenfläche. Die haftvermittelnde Fläche kann so vergrößert werden.

Insbesondere kann sich der Haftvermittler von einer ersten Seitenfläche ausgehend bis zur dem Strählformungsteil zugewandten Oberfläche des optoelektronischen Bauteils, entlang dieser Oberfläche über die Strahlungsdurchtrittsfläche des Gehäusekörpers bis zu der der ersten Seitenfläche gegenüberliegenden Seitenfläche und entlang dieser Seitenfläche erstrecken. Der Haftvermittler kann den Gehäusekörper insbesondere übergreifen. Die Stabilität der Befestigung wird so erhöht.

Gemäß zumindest einer weiteren Ausführungsform ist zwischen dem Strahlformungsteil, insbesondere einer Strahlungsein- bzw. -austrittsfläche des Strahlformungsteils, und der Strahlungsdurchtrittsfläche des Gehäusekörpers eine Brechungsindexanpassungsschicht angeordnet. Zweckmäßigerweise überdeckt die Brechungsindexanpassungsschicht die Strahlungsdurchtrittsfläche des Gehäusekörpers, insbesondere vollständig. Ferner grenzt die Brechungsindexanpassungsschicht bevorzugt an das Strahlformungsteil und/oder die Strahlungsdurchtrittsfläche des Gehäusekörpers an. Ein Brechungsindexsprung zwischen dem Strahlformungsteil und dem seitens der Strahlungsdurchtrittsfläche im optoelektronischen Bauelement angeordneten Material wird mittels der Brechungsindexanpassungsschicht zweckmäßigerweise gemindert.

Mit besonderem Vorteil bildet der Haftvermittler die Brechungsindexanpassungsschicht. Eine Strahlformung erfolgt im Strahlformungsteil bevorzugt im Wesentlichen mittels der dem optoelektronischen Bauelement abgewandten Oberfläche des Strahlformungsteils. Über die Brechungsindexanpassung kann im optoelektronischen Bauelement erzeugte oder zu empfangende Strahlung vereinfacht im Wesentlichen ohne optische Einflussnahme, zum Beispiel über Reflexion oder Brechung, auf den Strahlengang außerhalb des Strahlformungsteils geformt werden oder diese Einflussnahme kann gemindert werden. Das Ausbilden einer vorgegebenen Abstrahl- oder Empfangscharakteristik für das Verbund-Bauteil mittels des Strahlformungsteils wird so erleichtert.

Gemäß zumindest einer weiteren Ausführungsform enthält der Haftvermittler ein Silikon, insbesondere ein Silikongel, oder ein Silikon-Hybridmaterial. Derartige Materialien eignen sich besonders für den Haftvermittler mit gleichzeitiger brechungsindexanpassender Wirkung. Insbesondere gilt dies, falls das Strahlformungsteil ein Silikon oder ein Silikon-Hybridmaterial enthält und das seitens der Strahlungsdurchtrittsfläche des optoelektronischen Bauelements angeordnete Material, etwa die Chipumhüllung, ebenfalls ein Silikon oder Silikon-Hybridmaterial enthält.

Weiterhin grenzt der Haftvermittler bevorzugt unmittelbar an das optoelektronische Bauelement, das Trägerteil und/oder das Strahlformungsteil an.

Weitere Vorteile, vorteilhafte Ausgestaltungen und Zweckmäßigkeiten der Erfindung ergeben sich aus der folgenden Beschreibung der Ausführungsbeispiele in Verbindung mit den Figuren.
Figur 1 zeigt in den Figuren 1A bis 1D verschiedene schematische Ansichten eines Ausführungsbeispiels eines Trägerteils für ein optisches Element,
Figur 2 zeigt in den Figuren 2A und 2B verschiedene schematische Ansichten eines weiteren Ausführungsbeispiels eines Trägerteils für ein optisches Element,
Figur 3 zeigt eine schematische Schnittansicht eines Ausführungsbeispiels einer Anordnung mit einem Strahlformungsteils für ein optisches Element und einem Halbleiterchip,
Figur 4 zeigt eine Abstrahlcharakteristik der in Figur 3 gezeigten Anordnung,
Figur 5 zeigt in den Figuren 5A bis 5C verschiedene schematische Ansichten eines Ausführungsbeispiels eines optischen Elements, das ein Trägerteil und ein Strahlformungsteil umfasst,
Figur 6 zeigt in den Figuren 6A bis 6C verschiedene schematische Ansichten eines weiteren Ausführungsbeispiels eines optischen Elements, das ein Trägerteil und ein Strahlformungsteil umfasst,
Figur 7 zeigt in den Figuren 7A und 7B schematische Ansichten eines Ausführungsbeispiels eines Verbund-Bauteils mit einem optische Element, das an einem optoelektronischen Bauelement befestigt ist und
Figur 8 zeigt eine schematische Schnittansicht eines weiteren Ausführungsbeispiels eines Verbund-Bauteils mit einem optischen Element, das an einem optoelektronischen Bauelement befestigt ist.

Gleiche, gleichartige und gleich wirkende Elemente sind in den Figuren mit gleichen Bezugszeichen versehen.

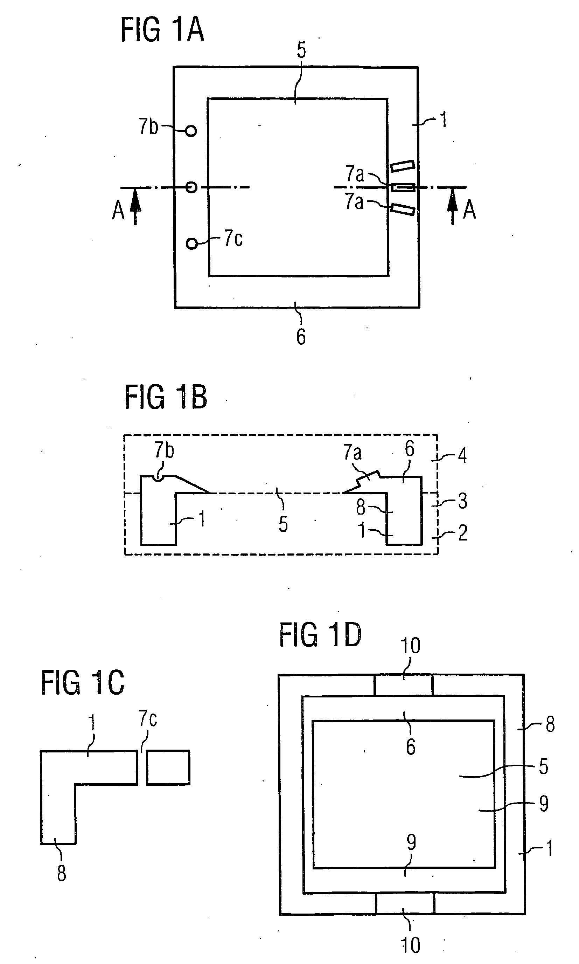

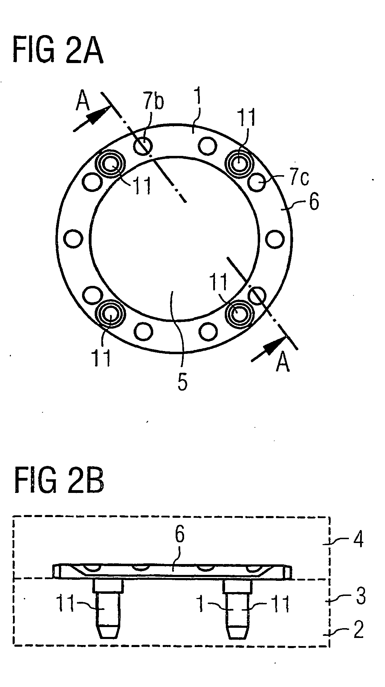

Figuren 1 und 2 zeigen in den Figuren 1A bis 1D beziehungsweise 2A und 2B verschiedene Ansichten jeweils eines Ausführungsbeispiels eines Trägerteils 1 für ein optisches Element.

Figur 1A zeigt eine schematische Aufsicht auf das Trägerteil 1 von oben, Figur 1B zeigt eine schematische Schnittansicht entlang der Linie A-A aus Figur 1A, Figur 1C zeigt eine Variante des Trägerteils anhand einer Teilschnittansicht und Figur 1D zeigt eine Aufsicht auf das Trägerteil von unten.

Figur 2A zeigt eine Aufsicht auf das Trägerteil 1 von oben und Figur 2B zeigt eine schematische Schnittansicht entlang der Linie A-A aus Figur 2A durch das Trägerteil 1.

Das Trägerteil 1 ist bevorzugt jeweils als, insbesondere einstückiges, Formteil ausgeführt. Das Trägerteil 1 enthält ferner bevorzugt einen Kunststoff, zum Beispiel einen Thermoplasten oder einen Duroplasten.

Das Trägerteil 1 kann mittels Gießen, insbesondere mittels Spritzgießen, in einer geeigneten Gussform 2, zum Beispiel einer Spritzgießform, hergestellt werden, die vorliegend lediglich in den schematischen Schnittansichten in den Figuren 1B beziehungsweise 2B gestrichelt angedeutet ist.

Die Gussform 2 weist bevorzugt zwei Teilformen 3 und 4 auf, zwischen denen eine Kavität zum Einfüllen, insbesondere Einspritzen, einer Formmasse für das Trägerteil gebildet ist. Die Kavität der Gussform 2 ist zweckmäßigerweise gemäß der gewünschten Form des Trägerteils 1 geformt. Nach dem Einfüllen der Formmasse in die Gussform wird die Formmasse vorzugsweise an- oder ausgehärtet, woraufhin das Trägerteil 1 aus der Gussform entformt werden kann. Die jeweiligen Teilformen 3 und 4 sind bevorzugt hinterscheidungsfrei ausgeführt, so dass auf kostenintensive Schieber in der Gussform für das Trägerteil 1 verzichtet werden kann und das Entformen des Trägerteils aus der Gussform erleichtert wird.

Das Trägerteil 1 ist jeweils derart ausgebildet, dass mittels des Trägerteils ein optisches Element, das das Trägerteil 1 und ein an das Trägerteil 1 anzuformendes Strahlformungsteil aufweist, an einem optoelektronischen Bauelement, insbesondere einen Gehäusekörper eines optoelektronischen Bauelements, befestigbar ist (vergleiche die im Zusammenhang mit den folgenden Figuren beschriebenen Ausführungsbeispiele) .

Das Material für das Trägerteil ist bevorzugt hinsichtlich hoher mechanischer Stabilität ausgewählt. Bevorzugt ist das Trägerteil 1 aus dem Material oder einer entsprechenden Materialzusammensetzung gefertigt, aus dem der Gehäusekörper des optoelektronischen Bauelements, an dem das optische Element befestigt werden soll, hergestellt ist. Die Gefahr von Beeinträchtigungen der mechanischen Stabilität der Befestigung des optischen Elements am optoelektronischen Bauelement wird aufgrund der dann optimal angepassten thermischen Ausdehnungskoeffizienten des Trägerteils und des Gehäusekörpers maßgeblich verringert. Ein Thermoplast, z.B. ein Polyamid, insbesondere Polyphthalamid (PPA), wird häufig bei Gehäusekörpern eingesetzt und ist hinsichtlich mechanischer Stabilität und thermischer Anpassung daher auch für das Trägerteil 1 besonders geeignet. Zudem kann das Trägerteil 1 aus einem für eine vom optoelektronischen Bauelement zu erzeugende oder zu empfangende Strahlung strahlungsundurchlässigen Material oder einer entsprechenden Materialzusammensetzung, z.B. PPA enthaltend, gebildet sein.

Ein Kunststoff für das Trägerteil kann mit einem oder einer Mehrzahl verschiedener Zusatzstoffe, z.B. Partikeln, wie TiO₂-Partikeln, und/oder Glasfasern, versetzt sein. Ein Kunststoff (z.B. ein Kunststoff mit dem Handelsnamen Grivory HT), wie PPA, das mit TiO₂-Partikeln und Glasfasern versetzt ist, zeichnet sich durch besonders geringe Strahlungsdurchlässigkeit, insbesondere für blaues oder weißes Licht, aus und ist gegenüber hohen Temperaturen, die z.B. beim Löten auftreten können, besonders stabil und daher für das Trägerteil, wie oben und im folgenden näher erläutert, besonders geeignet.

Das jeweilige Trägerteil 1 weist ein Anformteil 6 auf, das für das Anformen eines Strahlformungsteils für das optische Element an das Trägerteil 1 vorgesehen ist. Im Anformteil 6, das bevorzugt einstückig und/oder rahmenartig ausgeführt ist, ist eine Apertur 5 ausgebildet. Das Anformteil 6 umläuft die Apertur 5 bevorzugt lateral, insbesondere vollständig. Durch die Apertur kann Strahlung durch das gegebenenfalls strahlungsundurchlässig ausgeführte Trägerteil 1 hindurch treten.

In dem Anformteil 6 des jeweiligen Trägerteils sind Verbindungselemente 7a, 7b oder 7c ausgebildet. Die jeweiligen Verbindungselemente 7a, 7b beziehungsweise 7c sind bevorzugt derart ausgebildet, dass die direkte Kontaktfläche zwischen dem Trägerteil und dem an dieses anzuformenden Strahlformungsteil erhöht ist. Die mechanische Stabilität der Verbindung zwischen dem Trägerteil 1 und dem Strahlformungsteil kann hierdurch erhöht werden. Das Verbindungselement 7c ist lediglich in einer Teilschnittansicht des Trägerteils dargestellt.

Zweckmäßigerweise sind die Verbindungselemente an einer dem anzuformenden Strahlformungsteil zugewandten Oberfläche des Anformteils ausgebildet. Die Verbindungselemente 7a sind als Erhebungen, zum Beispiel stegartig, ausgeführt. Die Verbindungselemente 7b sind als Vertiefungen, zum Beispiel punktuelle Vertiefungen oder gegebenenfalls als umlaufende Nut (nicht dargestellt), ausgeführt. Die Verbindungselemente 7c sind als, insbesondere punktuelle, Aussparungen ausgeführt. Die Verbindungselemente sind.jeweils im Anformteil 6 ausgebildet. Erhebungen als Verbindungselemente sind in Figur 2 nicht explizit dargestellt, können jedoch selbstverständlich auch bei dem dort gezeigten Trägerteil 1 vorgesehen sein.

Ferner kann entgegen der Darstellung auch eine Vielzahl, insbesondere ausschließlich, gleichartiger Verbindungselemente 7a, 7b beziehungsweise 7c vorgesehen sein. Die Darstellung verschiedener Verbindungselemente am Trägerteil in den Figuren 1 und 2 ist diesbezüglich lediglich exemplarisch zu verstehen. Die Verbindungselemente sind ferner bevorzugt - entgegen der exemplarischen Darstellung in Figur 1 - gleichmäßig, insbesondere äquidistant, über das Trägerteil 1, insbesondere das Anformteil 6, verteilt. Hierdurch wird die Stabilität einer Verbindung zwischen dem Trägerteil und dem anzuformenden Strahlformungsteil lateral umlaufend erhöht.

Die in den Figuren 1 und 2 dargestellten Trägerteile 1 unterscheiden sich in der Art der Befestigung am optoelektronischen Bauelement für die das Trägerteil vorgesehen ist.

Das in Figur 1 dargestellte Ausführungsbeispiel des Trägerteils 1 ist für ein optisches Element, das über den Gehäusekörper eines optoelektronischen Bauelements stülpbar oder in das das optoelektronische Bauelement einlegbar ist, besonders geeignet. Hierzu weist das Trägerteil ein Befestigungsteil 8 auf, das bevorzugt an die laterale Abmessungen des Bauelements, insbesondere eines Gehäusekörpers des Bauelements, angepasst ist. Das Befestigungsteil 8 ist vorzugsweise rahmenartig ausgeführt. Ein Freiraum 9, den das Befestigungsteil bevorzugt zumindest zum Teil lateral begrenzt oder vorzugsweise insbesondere vollständig umläuft, kann für das Überstülpen oder Einlegen eine einhüllende Grundform aufweisen, die derjenigen des jeweiligen Gehäusekörpers des optoelektronischen Bauelements entspricht.

Bevorzugt weist der Freiraum 9 eine laterale Ausdehnung auf, die größer ist als diejenige der Apertur 5 im Anformteil 6. Die Apertur 5 und der Freiraum 9 können voneinander verschiedene einhüllende Grundformen aufweisen. Der Freiraum 9 ist bevorzugt für das Einlegen oder Überstülpen ausgebildet, wobei die Apertur 5 für den Strahlungsdurchtritt vorgesehen ist. Beispielsweise weist der Freiraum 9 eine in Aufsicht rechteckige, das heißt insbesondere nicht quadratische, einhüllende Grundform mit verschieden langen Seiten auf. Die Apertur 5 kann eine quadratische einhüllende Grundform aufweisen.

Der Querschnitt des Anformteils 6 verjüngt sich bevorzugt in Richtung der Apertur 5, besonders bevorzugt derart, dass sich die Apertur in Richtung der Oberfläche, an die das Strahlformungsteil anzuformen ist, d.h. insbesondere der dem Befestigungsteil 8 abgewandten Oberfläche, verbreitert. Ein großflächiger Strahlungsdurchtritt eines breiten Strahlenbündels durch die Apertur wird so bei gleichzeitig vergrößerter zur Anformung zur Verfügung stehenden Oberfläche erleichtert.

In dem Befestigungsteil 8 sind bevorzugt Ausnehmungen 10, insbesondere an gegenüberliegenden Seiten, ausgebildet. Durch diese Ausnehmungen 10 können Anschlussleiter des optoelektronischen Bauelements für die externe elektrische Kontaktierung des eingelegten Bauelements nach außen geführt werden.

Alternativ oder zusätzlich können die Ausnehmungen 10 als Justage- beziehungsweise Orientierungshilfen beim orientierten Aufsetzen des optischen Elements auf das optoelektronische Bauelement dienen. Dies ist von besonderem Vorteil, falls das Bauelement, insbesondere dessen Gehäusekörper, in Aufsicht eine Grundform aufweist, auf die das Trägerteil abgestimmt ist, und die, wie etwa eine echt rechteckige Grundform, ein orientiertes Aufsetzen erfordert.

Das in Figur 2 dargestellte Ausführungsbeispiel des Trägerteils 1 ist für ein Aufstecken des optischen Elements auf das optoelektronische Bauelement besonders geeignet. Hierzu sind bevorzugt stiftartige Befestigungselemente 11 am Trägerteil 1, die zum Eingreifen in korrespondierenden Montagevorrichtungen des optoelektronischen Bauelements, insbesondere dessen Gehäusekörper, geeignet sind, ausgebildet. Die Befestigungselemente 11 sind weiterhin bevorzugt an der dem anzuformenden Strahlformungsteil abgewandten Seite angeschrägt ausgeführt. Bei einem bezüglich der Montagevorrichtung leicht dejustierten Aufsetzen des optischen Elements auf das Bauelement können die Befestigungselemente so vereinfacht der jeweils korrespondierenden Montagevorrichtung zugeführt werden und insbesondere in die Montagevorrichtung "einrutschen".

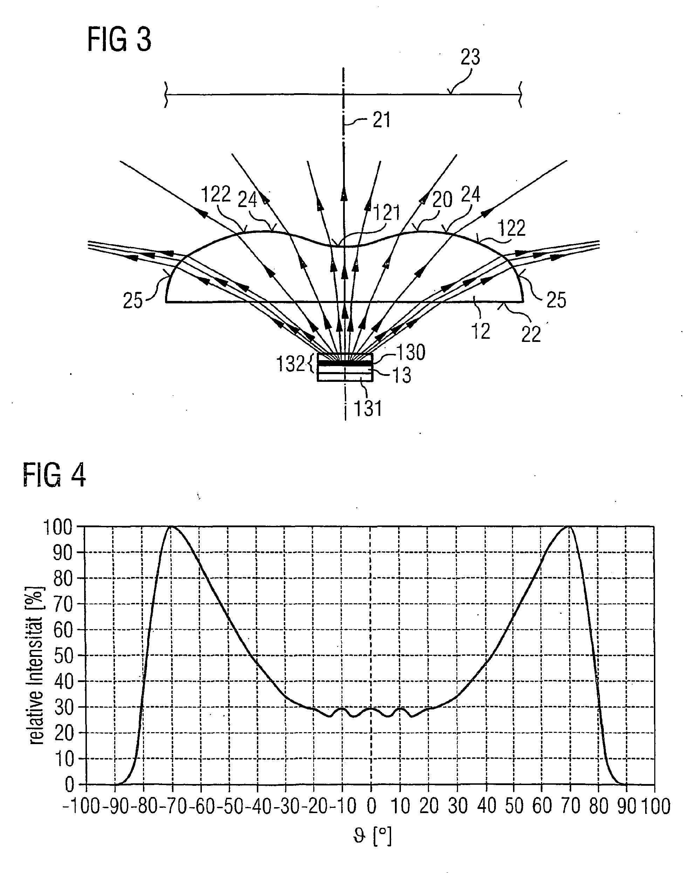

Figur 3 zeigt schematisch eine Schnittansicht einer besonderen Ausführungsform eines Strahlformungsteils 12 für ein optisches Element. Weiterhin sind die Strahlformungseigenschaften des Strahlformungsteils anhand des Strahlengangs schematisch dargestellt. Hierbei dient bevorzugt ein optoelektronischer Halbleiterchip 13 als Strahlungsquelle.

Das Strahlformungsteil enthält ein Silikon-Hybridmaterial. Diese Materialien sind selbst bei hochenergetischer kurzwelliger Strahlung, etwa ultravioletter oder blauer Strahlung, die mittels des Halbleiterchips erzeugbar sein kann über eine maßgebliche Dauer im Wesentlichen form- und transmissionsbeständig.

Silikone sind in der Regel sehr flexibel und leicht biegbar. Weiterhin kann bereits eine kleine Beschädigung, z.B. ein Riss, in einem Silikon-Formteil die Gesamtstabilität des Formteils derart beeinträchtigen, dass das Formteil bei geringer Krafteinwirkung zerstört wird.

Silikon-Hybride, etwa ein Silikon und ein Epoxidharz enthaltend, sind gegenüber einem Epoxidharz strahlungsstabiler und zeigen ein ähnliches chemisches Haftungsverhalten. Insbesondere haften Hybride in der Regel besser als reine Silikone. Die Degradationsgeschwindigkeit der optischen Eigenschaften eines Hybrids kann maßgeblich über derjenigen ähnlicher Materialien, z.B. eines Epoxidharzes, liegen. Die Degradation von Hybriden kann gegenüber der Degradation optisch vergleichbarer Materialien um das 5-Fache oder mehr, insbesondere bis zum 1000-Fachen oder darüber hinaus verlangsamt sein.

Die Strahlformung wird lediglich exemplarisch für einen strahlungsemittierenden Halbleiterchip dargestellt. Der Strahlengang ist selbstverständlich umkehrbar. In diesem Falle ist der Halbleiterchip zweckmäßigerweise als Strahlungsdetektorchip ausgeführt.

Eine Strahlungsaustrittsfläche 20 des Strahlformungsteils 12 weist einen konkav gekrümmten Teilbereich 121 und einen den konkav gekrümmten Teilbereich in einem Abstand zur optischen Achse. 21 umgebenden, insbesondere vollständig umlaufenden, konvex gekrümmten Teilbereich 122 auf.

In einer aktiven Zone 130 des optoelektronischen Halbleiterchips 13 erzeugte Strahlung tritt über eine Strahlungseintrittsfläche 22, die vorzugsweise eben ausgeführt ist, in das Strahlformungsteil 12 ein. Die vom Halbleiterchip erzeugte Strahlung, insbesondere sichtbare Strahlung, wird in Figur 3 durch die mit Pfeilen gekennzeichneten Linien, welche den Strahlengang anhand einzelner Strahlen andeuten, verdeutlicht. Die optische Achse 21 verläuft durch den Halbleiterchip 13 und den konkav gekrümmten Teilbereich..

Der Halbleiterchip 13 umfasst einen auf einem Träger 131 angeordneten Halbleiterkörper 132, der wiederum die zur Strahlungserzeugung geeignete aktive Zone 130 umfasst. Auf der dem Strahlformungsteil abgewandten Seite der aktiven Zone kann eine Spiegelschicht, z.B. zwischen dem Träger und dem Halbleiterkörper, angeordnet sein, die durch Reflexion Strahlung in Richtung der dem Strahlformungsteil zugewandten Oberfläche des Halbleiterchips richtet. Bevorzugt ist die Spiegelschicht elektrisch leitend, etwa metallhaltig, z.B. ein Metall oder eine Legierung enthaltend, ausgeführt. Vorzugsweise ist die Spiegelschicht metallisch oder legierungsbasiert ausgeführt. Die Spiegelschicht ist weiterhin bevorzugt elektrisch leitend mit der aktiven Zone verbunden und kann so vereinfacht zusätzlich zur Reflexion an der elektrischen Kontaktierung des Chips beteiligt sein. In diesem Falle ist der Träger bevorzugt von einem Aufwachssubstrat, auf dem eine Halbleiterschichtenfolge für den Halbleiterkörper epitaktisch gewachsen ist, verschieden.

Die Anordnung mit dem Strahlformungsteil 12 und dem Halbleiterchip 13 ist zur homogenen Beleuchtung, insbesondere zur Hinterleuchtung einer Fläche 23, etwa einer Diffusorfolie oder einer Anzeigevorrichtung, wie einem LCD, besonders geeignet. Die optische Achse 21 verläuft bevorzugt durch die Fläche 23. Besonders bevorzugt verläuft die Fläche 23 im Wesentlichen senkrecht zur optischen Achse 21.

Über geeignete Ausbildung der Krümmungen des konvex und des konkav gekrümmten Teilbereichs kann die vom Halbleiterchip erzeugte Strahlung strahlungsaustrittsseitig derart verteilt werden, dass die Fläche gleichmäßig und homogen ausgeleuchtet wird. Auf verschiedene, gleichgroße und beleuchtete Bereiche der Fläche trifft mit Vorzug jeweils im Wesentlichen die gleiche Strahlungsleistung.

Über den konkaven Teilbereich 121 austretende Strahlung wird ähnlich wie bei einer Zerstreuungslinse gestreut. Insbesondere wird unter einem von 90° verschiedenen Winkel zur optischen Achse auf die Strahlungsaustrittsfläche 20 auftreffende Strahlung dort von der optischen Achse weg gebrochen. Die über den konkaven Teilbereich austretende Strahlung dient der homogenen Ausleuchtung eines die optische Achse 21 umgebenden Bereichs der Fläche 23.

Vergleichsweise weit von der optischen Achse beabstandete Bereiche der Fläche 23 werden mittels über den konvex gekrümmten Teilbereich 122 - unter einem von 90° verschiedenen Winkel zur optischen Achse 21 - aus dem Strahlformungsteil austretender Strahlung beleuchtet.

Der Übergangsbereich zwischen dem konkaven und dem konvexen Teilbereich ist mit Vorzug glatt, insbesondere kantenfrei, ausgebildet ist. Insbesondere kann die Strahlungsaustrittsfläche, bevorzugt vollflächig, differenzierbar ausgeführt sein. Eine homogene Ausleuchtung der Fläche 23 wird so erleichtert. Nicht differenzierbare Knicke würden die Gefahr des Entstehens unerwünschter Inhomogenitäten in der Strahlungsleistungsverteilung auf der zu beleuchtenden Fläche 23 erhöhen.

Der konvex gekrümmte Teilbereich 122 der Strahlungsaustrittsfläche 20 weist bevorzugt einen größeren Flächeninhalt auf als der konkav gekrümmte Teilbereich 121. In der Folge tritt gegenüber dem konkav gekrümmten Teilbereich ein erhöhter Anteil an Strahlung über den konvex gekrümmten Teilbereich seitlich und schräg zu optischen Achse aus dem Strahlformungsteil aus.

Weiterhin weist der konvex gekrümmte Teilbereich 122 bevorzugt einen ersten Bereich 24 einer ersten Krümmung und einen zweiten Bereich 25 einer von der ersten Krümmung verschiedenen zweiten Krümmung auf.

Die erste Krümmung ist hierbei bevorzugt kleiner als die zweite Krümmung. Aufgrund der im zweiten Bereich 25 größeren Krümmung weist in diesem Bereich aus dem Strahlformungsteil austretende Strahlung mit Vorteil einen größeren Winkel zur optischen Achse 21 auf als im ersten Bereich 24 oder im konkaven Teilbereich 121 aus dem Strahlformungsteil austretende Strahlung. Die homogene Ausleuchtung vergleichsweise weit von der optischen Achse entfernter Bereiche der Fläche 23 wird so erleichtert.

Bevorzugt tritt Strahlung aus dem Strahlformungsteil 12 im wesentlichen lediglich unter einem Winkel kleiner 90 Grad zur optischen Achse aus dem optischen Element aus. Die Abstrahlung verläuft somit hauptsächlich insbesondere seitlich oder quer zur optischen Achse und nach vorne in Richtung der optischen Achse. Das Strahlformungsteil 12 ist mit Vorzug derart ausgeführt, dass ein Großteil der Strahlungsleistung, vorzugsweise 60% oder mehr, unter einem Winkel zur optischen Achse, insbesondere größer als 60° und/oder über den.konvex gekrümmten Teilbereich 122, aus dem Strahlformungsteil austritt.

Die Krümmung des konvexen Teilbereichs 122 kann mit wachsendem Abstand vom konkav gekrümmten Teilbereich, insbesondere im zweiten Bereich 25 in Richtung der Strahlungseintrittsfläche 22 zunehmen, wodurch eine vermehrte Auskopplung von Strahlung unter großen Winkeln zur optischen Achse und damit das Beleuchten vergleichsweise weit von der optischen Achse entfernten Bereichen der Fläche 23 gefördert wird.

Das Strahlformungsteil 12 kann derart ausgeführt sein, dass sich aus dem Strahlformungsteil austretende Strahlen nicht überschneiden, sodass die örtliche Strahlungsleistungsverteilung auf der zu beleuchtenden Fläche im wesentlichen unabhängig vom Abstand der Fläche zum Strahlformungsteil ist.

Würde das Strahlformungsteil bei der Strahlformung eine Überkreuzung von Strahlen hervorrufen, so könnte sich ein Fokalbereich ausbilden, so dass die örtliche Strahlungsleistungsverteilung auf der Fläche 23 abhängig vom Abstand der Fläche zum Strahlformungsteil wäre. Bei einer Variation des Abstandes der Fläche 23 zum Strahlformungsteil würden sich insbesondere Inhomogenitäten, etwa Ringe höherer Intensität, der örtlichen Strahlungsleistungsverteilung ausbilden. Diese Inhomogenitäten werden durch Überkreuzung von Strahlen hervorgerufen. Bei dem dargestellten Strahlformungsteil 12 ist jedoch, aufgrund der schnittfrei verlaufenden Strahlung, die örtliche Verteilung der Strahlungsleistung auf der Fläche 23 unabhängig vom Abstand der Fläche zur Strahlungsaustrittsfläche. Weiterhin erfolgt die Strahlformung oder die Strahlführung im Strahlformungsteil mit Vorzug totalreflexionsfrei.

Die Abstrahlcharakteristik des Halbleiterchips kann mittels des Strahlformungsteils verbreitert werden, so dass der mit dem Halbleiterchip zu beleuchtende Teilbereich der Fläche gegenüber einer unmittelbaren Beleuchtung mit dem Halbleiterchip bei einem vorgegeben Abstand des Halbleiterchips von der Fläche vergrößert ist. Alternativ kann der Halbleiterchip bei einer zu beleuchtenden Fläche einer vorgegebenen Größe mit Vorteil aufgrund der Strahlformung im Strahlformungsteil näher an der zu beleuchtenden Fläche angeordnet werden.

Für eine azimutal um die optische Achse 21 umlaufend gleichförmige Abstrahlcharakteristik der Beleuchtungsvorrichtung ist die Strahlungsaustrittsfläche 20, insbesondere das gesamte Strahlformungsteil, mit Vorzug rotationssymmetrisch zur optischen Achse ausgeführt. In nicht zur Strahlformung vorgesehenen Bereichen kann gegebenenfalls von der rotationssymmetrischen Ausführung abgewichen werden.

Figur 4 zeigt ein Beispiel für eine Abstrahlcharakteristik der in Figur 3 gezeigten Anordnung nach der Strahlformung am Strahlformungsteil. Aufgetragen ist die relative Intensität in Prozent in Abhängigkeit vom Winkel ϑ in ° zur optischen Achse.

Die hier gezeigte Abstrahlcharakteristik wurde für ein Strahlformungsteil gemäß Figur 3, das rotationssymmetrisch zur optischen Achse ausgeführt ist, und einen Halbleiterchip ermittelt, der im Abstand von 0,6 mm von der Strahlungseintrittsfläche 22 angeordnet war.

Die Anordnung emittiert einen Großteil der Strahlungsleistung seitlich zur optischen Achse, insbesondere unter vergleichsweise großen Winkeln. Bevorzugt liegt ein lokales Minimum der Charakteristik im Bereich des konkav gekrümmten Teilbereichs, insbesondere innerhalb des konkav gekrümmten Teilbereichs und/oder im Winkelbereich zwischen 0° und 10°.

Weiterhin emittiert die Anordnung bevorzugt mehr als 50 %, besonders bevorzugt mehr als 60% der vom Halbleiterchip erzeugten Strahlungsleistung in einen Winkelbereich zwischen 80° und 40° zur optischen Achse.

Das. Maximum der Intensität liegt bei einem Winkel größer 60°, insbesondere bei ungefähr 70°. Von dem konkaven Teilbereich, der dem Bereich um 0° entspricht, ausgehend wächst die Intensität mit steigendem Winkel, d.h. in Richtung des konvex gekrümmten Teilbereichs, in etwa gemäß einer Potenzfunktion, insbesondere gemäß einer Parabel, und fällt nach dem Erreichen des Maximums steil ab.

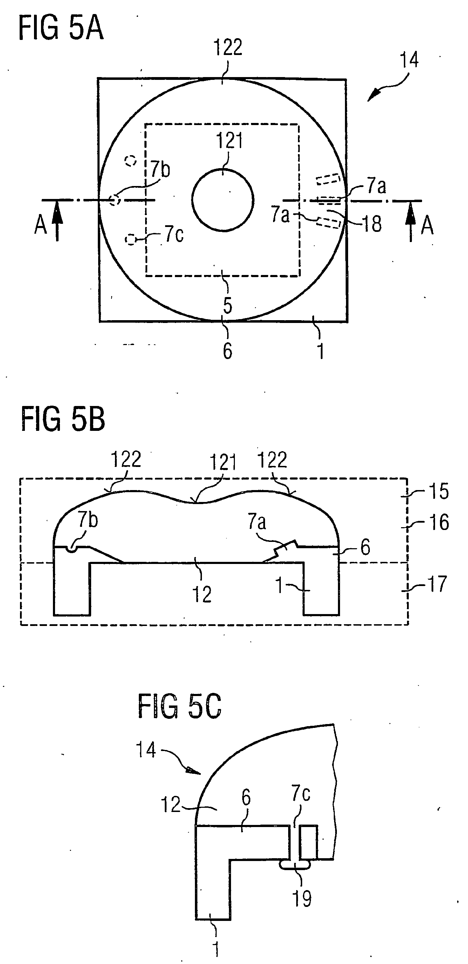

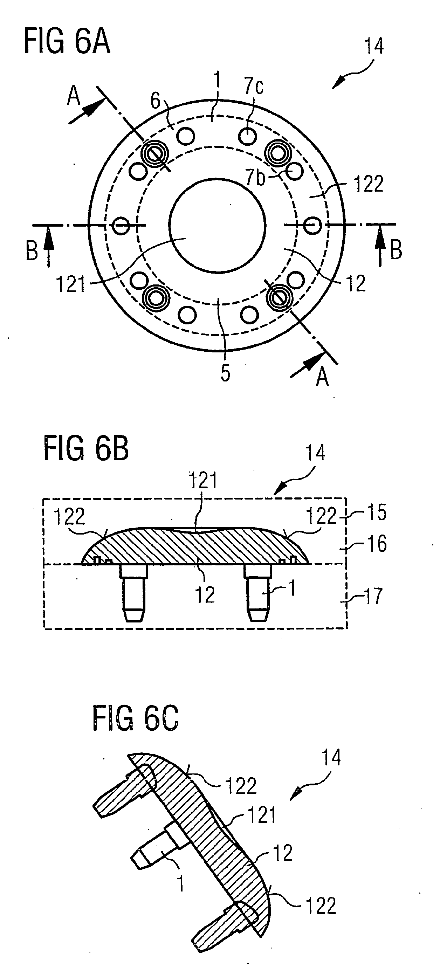

Die Figuren 5 und 6 zeigen in den Figuren 5A bis 5C und 6A bis 6C verschiedene schematische Ansichten eines optischen Elements 14, das ein Trägerteil 1 und ein Strahlformungsteil 12 umfasst.

Das Trägerteil 1 gemäß Figur 5 entspricht dem in Zusammenhang mit Figur 1 beschriebenen Trägerteil und das Trägerteil 1 gemäß Figur 6 dem in Zusammenhang mit Figur 2 beschriebenen Trägerteil. Das Strahlformungsteil 12 entspricht jeweils im Wesentlichen der im Zusammenhang mit den Figuren 3 und 4 beschriebenen Grundstruktur des Strahlformungsteils 12.

Figur 5A zeigt eine schematische Aufsicht auf das optische Element 14 von oben, Figur 5B zeigt eine schematische Schnittansicht entlang der Linie A-A aus Figur 5A und Figur 5C zeigt eine schematische Teilschnittansicht des optischen Elements 14.

Figur 6A zeigt eine schematische Aufsicht auf das optische Element 14 von oben, Figur 6B zeigt eine schematische Schnittansicht entlang der Linie B-B aus Figur 6A und Figur 6C zeigt eine schematische Schnittansicht entlang der Linie A-A aus Figur 6A.

Die optischen Elemente 14 gemäß den Figuren 5 und 6 weisen jeweils ein Trägerteil 1 und ein Strahlformungsteil 12 auf, wobei das Strahlformungsteil 12 an das Trägerteil angeformt ist. Das Strahlformungsteil 12 enthält ein Silikon-Hybridmaterial, oder besteht hieraus. Dieser Kunststoff ist von der Grundformmasse für das Trägerteil 1 verschieden.

Das Anformen erfolgt bevorzugt mittels eines Gussverfahrens, zum Beispiel eines Spritzgussverfahrens. Das zuerst hergestellte, vorzugsweise ausgehärtete, Trägerteil 1 wird hierzu in eine für das Strahlformungsteil 12 geformte Gussform 15 eingelegt, woraufhin eine von der für das Trägerteil 1 eingesetzten Formmasse verschiedene Formmasse, etwa eine Silikon-Hybrid-Formmasse, für das Strahlformungsteil an das Trägerteil angegossen, insbesondere angespritzt, wird. Bevorzugt wird die Formmasse auf das Trägerteil 1 aufgespritzt. Die Gussform 15 mit den Teilformen 16 und 17, die eine Kavität für das Strahlformungsteil bilden, ist in den Figuren 5B und 6B gestrichelt und lediglich schematisch dargestellt.

Die in die Form gefüllte fließfähige Formmasse für das Strahlformungsteils formt sich an das Trägerteil und insbesondere an die am Anformteil 6 ausgebildeten Verbindungselemente 7a, 7b und 7c an. Nachfolgend wird die Formmasse, insbesondere temperaturgestützt, etwa durch Abkühlen, und/oder durch Vernetzen, ausgehärtet. Die Formmasse zieht sich bevorzugt beim Härten zusammen, so dass sich eine mechanisch stabile Verbindung zwischen dem Trägerteil 1 und dem Strahlformungsteil 12 ausbildet, ohne dass zusätzlich ein Haftvermittler eingesetzt wird. Das Strahlformungsteil liegt bevorzugt unter Zugspannung. Die Flexibilität eines eigentlich flexiblen Materials, wie einem Silikon oder einem Silikon-Hybridmaterial, für das Strahlformungsteil kann so vermindert werden. Das Strahlformungsteil kann dann mit Vorteil nur mit einem gegenüber einem optischen Element, das lediglich das Material des Strahlformungsteils aufweist, höheren Kraftaufwand gebogen werden und weist eine erhöhte Stabilität auf.

Mittels eines 2K-Spritzgussverfahrens mit zwei verschiedenen Formen und Formmassen können das Trägerteil 1 und das Strahlformungsteil 12 vereinfacht auf die jeweilige Hauptfunktion hin - mechanische Stabilität für das Trägerteil und optische Eigenschaften für das Strahlformungsteil - optimiert werden.

Nach dem Härten wird das optische Element aus der Gussform 15 entformt.

Gegebenenfalls kann auch ein Trägerteil 1 an ein entsprechendes vorgeformtes Strahlformungsteil 12 angeformt werden. Da das Trägerteil 1 jedoch mit Vorzug die mechanische Stabilität des Strahlformungsteils gewährleistet, ist ein umgekehrtes Vorgehen bevorzugt.

Das Ausbilden einer mechanisch stabilen, insbesondere innigen Verbindung, zwischen dem Trägerteil 1 und dem Strahlformungsteil 12 wird durch die Verbindungselemente 7a, 7b beziehungsweise 7c gefördert. Diese sind lediglich in Figur 5 detailliert und schematisch dargestellt, können jedoch auch bei dem in Figur 6 gezeigten optischen Element 14 in entsprechender Weise vorgesehen sein.

Die Verbindungselemente 7a, die als Erhebung ausgeführt sind, sind mit dem Strahlformungsteil 12 umformt. Bevorzugt verringert sich die laterale Ausdehnung eines mittels zweier benachbarter Verbindungselemente 7a lateral begrenzten Zwischenraums 18 zwischen den Verbindungselementen in Richtung der Apertur 5. Beim Härten des Strahlformungsteils 12 kann so die Zugspannung und hierüber die Stabilität des Strahlformungsteils sowie dessen mechanische Anbindung an das Trägerteil 1 vereinfacht erhöht werden.

In das Verbindungselement 7b, das als Vertiefung ausgeführt ist, ist das Strahlformungsteil 12 eingeformt. Das Strahlformungsteil 12 greift insbesondere in das Trägerteil 1 ein. Die mechanische Stabilität der Verbindung kann ebenso wie die Zugspannung auf das Strahlformungsteil auch mittels des Verbindungselements 7b erhöht werden.

Das Verbindungselement 7c, das als durchgehende Aussparung im Anformteil 6 ausgebildet ist, wird beim Anformen durchformt, wobei sich auf der dem Strahlformungsteil 12 abgewandten Oberfläche des Trägerteils 1 eine nietenartige Ausbuchtung oder Auswölbung 19 ausbildet. Die mechanische Stabilität der Verbindung von Trägerteil und Strahlformungsteil 12 kann auch mittels eines derartigen Verbindungselements 7c erhöht werden.

Die Apertur 5 des Trägerteils 1 wird jeweils vollständig vom Strahlformungsteil 12 überdeckt. Die dem Trägerteil 1 abgewandte, strahlformende Oberfläche des Strahlformungsteils 12 mit dem konkav gekrümmten Teilbereich 121 und dem konvex gekrümmten Teilbereich 122 kann so vorteilhaft großflächig ausgebildet werden. Eine großflächige Ausleuchtung einer Fläche wird so vereinfacht.

Der konkav gekrümmte Teilbereich 121 ist bevorzugt oberhalb eines Zentralbereichs der Apertur 5 angeordnet. Eine Projektion des konkav gekrümmten Teilbereichs 121 in die Apertur 5 liegt vorzugsweise vollständig innerhalb der Apertur.

Das Strahlformungsteil 12 kann lateral über das Trägerteil 1 hinaus ragen. Hierdurch wird die dem Trägerteil abgewandte Oberfläche des Strahlformungsteils erhöht, wodurch die Strahlungsdurchtrittsfläche vergrößert werden kann. Zur Erhöhung der mechanischen Unterstützung des Strahlformungsteils kann das Strahlformungsteil jedoch gegebenenfalls lateral bündig mit dem Trägerteil abschließen oder das Trägerteil kann lateral über das Strahlformungsteil hinaus ragen.

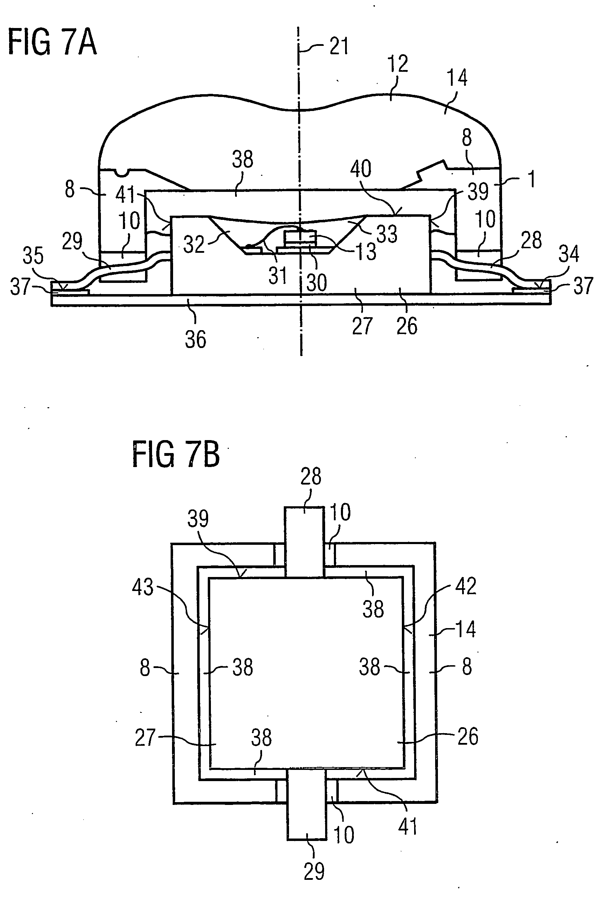

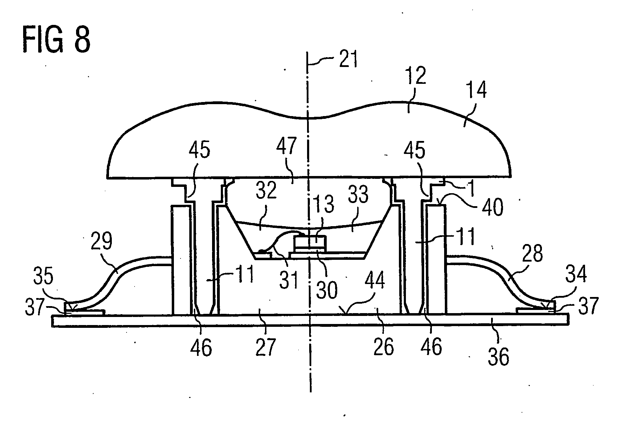

In den Figuren 7 und 8 sind optische Elemente 14 dargestellt, die an einem optoelektronischen Bauelement 25 befestigt sind. Figur 7A zeigt diesbezüglich eine schematische Schnittansicht, Figur 7B eine schematische Aufsicht von unten und Figur 8 eine schematische Schnittansicht jeweils eines derartigen Verbund-Bauteils.

Das optische Element 14 gemäß Figur 7 entspricht dem im Zusammenhang mit Figur 5 beschriebenen optischen Element und dasjenige gemäß Figur 8 dem im Zusammenhang mit Figur 6 beschriebenen optischen Element.

Das optoelektronische Bauelement 26 weist jeweils einen Gehäusekörper 27 und einen optoelektronischen Halbleiterchip 13, insbesondere zur Strahlungserzeugung, auf. Das optoelektronische Bauelement 26 weist weiterhin einen ersten elektrischen Anschlussleiter 28 und einen zweiten elektrischen Anschlussleiter 29 auf. Diese ragen bevorzugt an verschiedenen Seitenflächen, insbesondere gegenüberliegenden Seitenflächen, des Gehäusekörpers 27 aus diesem heraus. Die Anschlussleiter dienen der elektrischen Kontaktierung des Halbleiterchips 13 und sind hierzu zweckmäßigerweise elektrisch leitend mit diesem verbunden. Der Halbleiterchip 13 kann mit dem ersten Anschlussleiter 28 über eine Anschlussschicht 30, etwa eine elektrisch leitende Klebstoff- oder eine Lotschicht, elektrisch leitend verbunden und/oder auf diesem befestigt sein. Mit dem zweiten Anschlussleiter 29 ist der Halbleiterchip bevorzugt über einen Bonddraht 31 elektrisch leitend verbunden.

Das optoelektronische Bauelement 26, insbesondere der Gehäusekörper 27, kann mittels Umgießen, etwa mittels eines Spritzguss-, Spritzpressguss- oder Pressgussverfahrens, eines die beiden Anschlussleiter 28 und 29 umfassenden Leiterrahmens mit einer geeigneten Formmasse, etwa einem Kunststoffmaterial, insbesondere einem Thermoplasten, z.B. PPA, hergestellt werden. Nachfolgend kann der Halbleiterchip 13 mit den Anschlussleitern elektrisch leitend verbunden werden. Das optoelektronische Bauelement kann demnach ein vorgeformtes Gehäuse, ein sogenanntes prernolded-package aufweisen.

Bevorzugt weist der Gehäusekörper 27 eine Kavität 32 auf, in der der Halbleiterchip 13 besonders bevorzugt angeordnet ist. Weiterhin kann in der Kavität 32 eine Umhüllungsmasse 33 angeordnet sein, in die der Halbleiterchip 13 und vorzugsweise auch der Bonddraht eingebettet ist. Diese Umhüllung schützt den Halbleiterchip 13 und den Bonddraht 13 mit Vorteil vor schädlichen äußeren Einflüssen. Zweckmäßigerweise ist die Umhüllung strahlungsdurchlässig für eine im Halbleiterchip.13 zu erzeugende oder zu empfangende Strahlung ausgebildet.

Beispielsweise enthält die Umhüllung ein Silikon oder ein Silikon-Hybridmaterial. Diese Materialien zeichnen sich gegenüber hochenergetischer kurzwelliger, z.B. blauer oder ultravioletter Strahlung, die der Halbleiterchip bevorzugt erzeugen kann, durch hohe Beständigkeit in den optischen Eigenschaften, etwa der Transmission, über eine maßgebliche Bestrahlungsdauer aus.

Das optoelektronische Bauelement kann ferner zur Erzeugung mischfarbigen, insbesondere weißen Lichts, ausgebildet sein. Hierzu ist dem Halbleiterchip, etwa in der Umhüllungsmasse, ein Wellenlängenkonversionsmaterial nachgeordnet. Ein Teil der vom Halbleiterchip erzeugten Strahlung kann das Wellenlängenkonversionsmaterial, etwa einen Leuchtstoff, insbesondere in Partikelform, zur Emission längerwelliger Strahlung anregen. Aus der Mischung der vom Halbleiterchip erzeugten und der vom Wellenlängenkönversionsmaterial reemittierten Strahlung kann in der Folge mischfarbiges, insbesondere weißes, Licht entstehen. Zur Weißlichterzeugung sind eine vom Halbleiterchip 13 erzeugte Primärstrahlung im blauen Spektralbereich und eine vom Wellenlängenkonversionsmaterial reemittierte Strahlung im gelben Spektralbereich besonders geeignet.

Der Gehäusekörper 26 ist bevorzugt aus einem gut reflektierenden Material, etwa einem weißem Kunststoff, z.B. PPA, gefertigt. Die Wände der Kavität 32 können alternativ oder ergänzend zur Steigerung der Reflexion einer vom Halbleiterchip erzeugten Strahlung an der Wand der Kavität mit einem reflexionssteigernden Material, etwa einem Metall, beschichtet sein. Über Reflexion an der Wand der Kavität kann der Anteil der dem optischen Element 14 zur Strahlformung zugeführten Strahlung verglichen mit einem Gehäuse oder einem Gehäusekörper ohne Kavität 32 mit Vorteil erhöht werden.

Das optoelektronische Bauelement ist weiterhin bevorzugt oberflächenmontierbar (SMD: Surface Mountable Device) ausgebildet. Bei der Oberflächenmontage werden beispielsweise die Anschlussleiter 28 und 29 seitens von Lötflächen 34 bzw. 35 der Anschlussleiter auf externe elektrische Anschlussmittel (nicht dargestellt) eines-Anschlussträgers 36, z.B. den Leiterbahnen einer Leiterplatte, gelötet. Hierbei wird das optoelektronische Bauelement auf dem Anschlussträger angeordnet, wobei die Anschlussleiter mittels eines Lots 37 bei hohen Temperaturen von beispielsweise 250 °C oder höher, insbesondere unter Schmelzen des Lots, mit den externen elektrischen Anschlussmitteln verlötet werden.

Es sei angemerkt, dass das Gehäuse auch als sogenanntes Overmold-Gehäuse oder als Gehäuse einer Radial-LED, bei dem der Chip und die Anschlussleiter nach der Montage des Chips auf den Anschlussleitern durchgehend mit dem Gehäusematerial umformt wird, ausgeführt sein kann. Zweckmäßigerweise ist das Material des Gehäusekörpers für den Strahlungsdurchtritt dann strahlungsdurchlässig gewählt. Im Gegensatz zu Overmold-Bauformen sind Radial-Bauformen nicht für die Oberflächenmontagetechnik (SMT: Surface Mounting Technology) geeignet. Premolded-Gehäuse-Bauformen sind weiterhin für Hochleistungs-Bauelemente zur Erzeugung hoher Strahlungsleistungen besonders geeignet, da auf ein transparente Gehäusekörpermaterial verzichtet werden kann. Die Freiheitsgrade für die Auswahl des Materials sind so erhöht.

Bei herkömmlichen an einem Bauelement befestigten optischen Elementen besteht die erhöhte Gefahr, dass sich die optischen Elemente beim Lötvorgang temperaturbedingt verformen oder gar zerschmelzen oder sich die Befestigung des optischen Elements am Bauelement löst. Die Abstrahlcharakteristik eines derartigen herkömmlichen Verbund-Bauteils kann so maßgeblich beeinträchtigt werden. Reine Thermoplastlinsen aus einem strahlungsdurchlässigen Thermoplast sind beispielsweise bei Löttemperaturen über 250 °C nicht formbeständig und schmelzen an oder zerschmelzen sogar. Bei Linsen aus Silikon besteht eine erhebliche Gefahr, dass sich beim Lötvorgang die Befestigung am Bauelement löst.

Das Verbund-Bauteil mit dem optoelektronischen Bauelement 26, und dem an diesem befestigten optischen Element 14 ist aufgrund der vereinfachten Optimierung des Trägerteils 1 und des Strahlformungsteils 12 auf verschiedene Funktionen mit Vorteil zuverlässig mittels eines bleifreien Lötprozesses, bei dem zweckmäßigerweise ein bleifreies Lot eingesetzt wird, lötbar ausgeführt.

Für das Trägerteil 1 kommt bevorzugt ein Kunststoff zum Einsatz, der sich durch hohe mechanische Stabilität, gute Befestigungseigenschaften und/oder Anpassung des thermischen Ausdehnungskoeffizienten an denjenigen des Gehäuses auszeichnet. Ein strahlungsundurchlässiger Thermoplast oder ein gegebenenfalls strahlungsundurchlässiger Duroplast ist, für das Trägerteil besonders geeignet. Mit besonderem Vorteil weist das Trägerteil die gleiche Materialzusammensetzung wie der Gehäusekörper 27 auf und enthält oder besteht aus beispielsweise PPA.

Das Strahlformungsteil 12 enthält ein Silikon-Hybridmaterial. Diese Materialien zeichnen sich zwar durch gute Strahlungs- und Temperaturstabilität aus, sind aber, auch wegen der leichten Biegbarkeit, dieser Materialien nicht oder nur schwer dauerhaft mechanisch stabil am Bauelement befestigbar.

Das aneinander Anformen des Trägerteils 1 und des Strahlformungsteils 12 erleichtert das Ausbilden einer haftvermittlungsfreien, innigen und mechanisch stabilen Anbindung des Strahlformungsteils an das Trägerteil, wobei die Teile voneinander grundsätzlich verschiedene Materialien enthalten können. Das optische Element kann trotz Einzelteilen aus verschiedenen Materialien in diesem Sinne einstückig ausgeführt sein.

Bei einem typischen bleifreien Lötprozess mit einer Löttemperatur von ca. 260 °C ist ein Verbund-Bauteil mit einem derart optimierten optischen Element aus verschiedenen Materialien über die Lötdauer von beispielsweise 120 s sowohl hinsichtlich der Befestigung des optischen Elements am Bauelement als auch hinsichtlich der Form des Strahlformungsteils und der Strahlformungseigenschaften stabil.

Die in den Figuren 7 und 8 gezeigten Verbund-Bauteile unterscheiden sich in der Art und Weise, in der das optische Element 14 am optoelektronischen Bauelement 26 befestigt ist.

Das optische Element 14 des in Figur 7 gezeigten Verbund-Bauteils ist über das optoelektronische Bauelement 26 gestülpt bzw. ist das optoelektronische Bauelement in das optische Element eingelegt. das optische Element und das Bauelement sind dabei derart relativ zueinander orientiert, dass die Anschlussleiter 28 und 29 über den Bereich der Ausnehmungen 10 im Befestigungsteil 8 des Trägerteils nach außerhalb des vom optischen Element überdeckten Bereichs des Bauelements 26 verlaufen oder entsprechend durch diese Ausnehmungen geführt sind.

Die Befestigung erfolgt im wesentlichen über eine haftvermittelnde Schicht 38, die zwischen dem optischen Element und dem Bauelement angeordnet ist und, vorzugsweise vollflächig, insbesondere über ihre gesamte Ausdehnung an das optoelektronische Bauelement und das optische Element, insbesondere das Strahlformungsteil 12 und das Trägerteil 1, angrenzt.

Die haftvermittelnde Schicht 38 erstreckt sich bevorzugt von einer das optoelektronische Bauelement lateral begrenzenden Seitenfläche 39, insbesondere einer äußersten Seitenfläche des Gehäusekörpers 27, ausgehend entlang des Befestigungsteils 8 bis zu und entlang der dem Strahlformungsteil 12 zugewandten Oberfläche des Bauelements, insbesondere des Gehäusekörpers. Im weiteren Verlauf erstreckt sich die Schicht 38 durchgehend entlang der Umhüllung 33, deren dem Halbleiterchip abgewandte Oberfläche vorliegend die Strahlungsdurchtrittsfläche des Bauelements bildet, und bis zu und entlang der der Ausgangsseitenfläche gegenüberliegenden Seitenfläche 41 des optoelektronischen Bauelements. Bevorzugt ist die Schicht 38 an zwei weiteren, insbesondere gegenüberliegenden, Seitenflächen 42 und 43 des optoelektronischen Bauelements angeordnet, wobei der Verlauf der Schicht bevorzugt dem oben beschriebenen entspricht.

Bevorzugt enthält die Schicht 38 ein Silikon, insbesondere ein Silikongel, oder ein Silikon-Hybridmaterial oder besteht hieraus. Diese Materialien, insbesondere ein Silikongel, zeichnen durch gute Haftvermittlung, insbesondere zwischen den weiter oben angeführten, für den Gehäusekörper und das Trägerteil einsetzbaren Materialien, aus. Ferner sind diese Materialien auch zur Brechungsindexanpassung des Strahlformungsteils 12 an das strahlungsdurchlässige Umhüllungsmaterial 33 geeignet. Eine Brechungsindexanpassung kann besonders effizient erfolgen, falls das Umhüllungsmaterial, das Strahlformungsteil und die haftvermittelnde Schicht 38 jeweils ein Silikon bzw. gegebenenfalls ein Silikon-Hybridmaterial enthalten.

Mittels der haftvermittelnden Schicht 38 kann weiterhin die Flexibilität des Strahlformungsteils verringert bzw. die Festigkeit erhöht werden.

Das Trägerteil 1, insbesondere dessen Befestigungsteil 8, und/oder die haftvermittelnde Schicht 38 umgreifen bevorzugt den Gehäusekörper 27 und umlaufen diesen besonders bevorzugt lateral, insbesondere vollständig. Weiterhin kann das Befestigungsteil vom Gehäusekörper großflächig, insbesondere vollständig, lateral beabstandet sein. Das.Befestigungsteil kann eine äußerste Seitenfläche des Gehäusekörpers lateral beabstandet umgreifen oder, insbesondere vollständig, umlaufend.

Die Umhüllung 33 ist weiterhin bevorzugt vollständig mit der Schicht 38 bedeckt. Eine zuverlässige optische Anbindung des optischen Elements, sowohl in optischer Hinsicht mit geringem Brechungsindexsprung, als auch in mechanischer Hinsicht mit einer großen haftvermittelnden Fläche kann so auf vorteilhaft einfache Weise erzielt werden. Insbesondere kann auf zusätzliche Montagevorrichtungen, etwa Rastvorrichtungen oder ähnliches, die im optoelektronischen Bauelement ausgebildet sind, verzichtet werden.

Das optische Element kann insbesondere ausschließlich an der (den) Seitenfläche(n) des Gehäusekörpers und/oder der dem Strahlformungsteil zugewandten Oberfläche des Bauelements und insbesondere des Gehäusekörpers befestigt sein.

Das Trägerteil 1 und insbesondere das Befestigungsteil 8 begrenzt und/oder berandet bevorzugt eine wannen- oder trogartige Ausnehmung im optischen Element, in die das Bauelement eingelegt werden kann. Diese Ausnehmung kann vor dem Einlegen mit einer vorgegebenen Menge an Material für die Schicht 38 befüllt werden. Nachfolgend kann das Bauelement eingelegt und das Material, etwa mittels Vernetzen, an- oder ausgehärtet werden. Die Menge an Material ist bevorzugt so gewählt, dass die sich ausbildende Schicht 38 vom optischen Element innerhalb des optischen Elements verbleibt und insbesondere vom optischen Element ausgehend nicht über das Trägerteil 1 hinaus verläuft.

Bei dem in Figur 8 schematisch gezeigten Verbund-Bauteil ist das optische Element 14 auf das optoelektronische Bauelement aufgesteckt und mittels einer Mehrzahl von Befestigungselementen 11 am Bauelement befestigt. Die Befestigungselemente 11 greifen hierzu in, insbesondere als Ausnehmungen oder Aussparungen im Gehäusekörper 27 ausgebildete, Montagevorrichtungen 46 des optoelektronischen Bauelements 26 ein. Die Montagevorrichtungen verlaufen bevorzugt von der dem Strahlformungsteil 12 zugewandten Oberfläche 40 ausgehend in den Gehäusekörper hinein und sind insbesondere lateral umlaufend vom Gehäusekörper begrenzt. Besonders bevorzugt verlaufen die Montagevorrichtungen durchgehend bis zu einer der Oberfläche 40 gegenüberliegenden, dem Strahlformungsteil 12 abgewandten Oberfläche 44 des Gehäusekörpers 27.

Über am oder im Trägerteil 1, insbesondere den Befestigungselementen 11, ausgebildete Abstandhalter 45, die etwa jeweils als Vorsprung des entsprechenden Befestigungselements 11 ausgeführt sind, kann eine vorgegebener Abstand zwischen dem Strahlformungsteil 12 und dem Halbleiterchip 13 vereinfacht eingehalten werden. Die Abstandhalter 45 sitzen hierfür bevorzugt auf dem optoelektronischen Bauelement 26, insbesondere dem Gehäusekörper, auf.

Die Befestigung des optischen Elements 14 am optoelektronischen Bauelement 26 kann mittels der Befestigungselemente beispielsweise über einen innerhalb der Montagevorrichtung angeordneten Klebstoff, eine Presspassung, eine Heisspresspassung, thermisches Nieten, Verstemmen oder Heißverstemmen erfolgen.

Zwischen dem Strahlformungsteil 12 und der Umhüllung 33 und insbesondere dem Halbleiterchip 13 ist eine Brechungsindexanpassungsschicht 47 angeordnet, die etwa ein Silikongel enthalt, vorliegend jedoch nicht oder nicht maßgeblich an der Befestigung beteiligt ist.

Ein für ein Verbund-Bauteil, etwa gemäß den Figuren 7 oder 8, insbesondere zur Erzeugung hoher Strahlungsleistung, besonders geeignetes optoelektronisches Bauelement, ist in der WO 02/084749 näher beschrieben. Dieses Bauelement weist zur Abfuhr der gegebenenfalls erheblichen Verlustwärme neben den elektrischen Anschlussleitern einen thermischen Anschlussleiter auf. Dieser kann separat verlötet werden und ist zur Wärmeabfuhr bevorzugt großflächig, insbesondere gegenüber den Lötflächen der Anschlussleiter betrachtet, ausgeführt. Ein wie oben beschriebenes, besonders lötstabiles optisches Element ist aufgrund der vergrößerten Lötfläche daher für ein Verbund-Bauteil mit diesem Bauelement von besonderem Vorteil.

Die Erfindung ist nicht durch die Beschreibung anhand der Ausführungsbeispiele beschränkt.

## Patentansprüche

1. Verbund-Bauteil mit einem optoelektronischen Bauelement (26) und einem an diesem Bauelement befestigten optischen Element (14) mit einem Trägerteil (1) und einem Strahlformungsteil (12), bei dem das Strahlformungsteil an das Trägerteil angeformt ist,
**dadurch gekennzeichnet,**
**dass** das Strahlformungsteil (12) ein Silikon-Hybridmaterial mit einem Silikon und mit einem Epoxidharz enthält, und
am oder im Trägerteil (1) mindestens ein Verbindungselement (7a, 7b, 7c) ausgebildet ist, wobei eine an das Trägerteil (1) angeformte Formmasse für das Strahlformungsteil (12) nach dem Anformen an- oder ausgehärtet und an das Verbindungselement (7a, 7b, 7c) angeformt ist, wobei eine mechanisch stabile Verbindung zwischen dem Trägerteil (1) und dem Strahlformungsteil (12) ausgebildet ist, und wobei das Strahlformungsteil (12) nach dem Härten unter Zugspannung steht.

2. Verbund-Bauteil nach Anspruch 1,
bei dem das optische Element (14) als Aufsatzoptik zum Aufsetzen auf das optoelektronische Bauelement (26) ausgebildet ist oder bei dem das optische Element (14) mittels des Trägerteils (1) am Gehäusekörper (26) befestigt ist.

3. Verbund-Bauteil nach einem der vorhergehenden Ansprüche, bei dem das optoelektronische Bauelement (26) einen Gehäusekörper (27) mit einer Strahlungsdurchtrittsfläche aufweist und das optische Element (14) am Gehäusekörper befestigt ist.

4. Verbund-Bauteil nach einem der vorhergehenden Ansprüche, bei dem das Strahlformungsteil (12) linsenartig ausgeführt ist und das Trägerteil (1) mit einem Thermoplasten oder mit
[ ]: das optische Element (14) mittels eines Mehrkomponenten- Gussverfahrens hergestellt ist und bei dem das Trägerteil (1) und das Strahefromonghsteie (12) in einer gemeinsamer Form hergestellt sind,
einem Duroplasten gebildet ist.

5. Verbund-Bauteil nach einem der vorhergehenden Ansprüche, bei dem das Trägerteil (1) aus einem für eine im optoelektronischen Bauelement (26) zu empfangende und/oder zu erzeugende Strahlung strahlungsundurchlässigen Material gefertigt ist.

6. Verbund-Bauteil nach einem der vorhergehenden Ansprüche, bei dem das Strahlformungsteil (12) durch das Verbindungselement (7a,7b,7c) nietenartig durchgeformt ist.

7. Verbund-Bauteil nach einem der vorhergehenden Ansprüche, bei dem am oder im Trägerteil (1) ein oder eine Mehrzahl von Befestigungselementen (11) ausgebildet ist, wobei das optoelektronische Bauelement (26) eine oder eine Mehrzahl von zu den Befestigungselementen korrespondierenden Montagevorrichtungen (46) aufweist, in die die Befestigungselemente für die Befestigung des optischen Elements (14) am optoelektronischen Bauelement (26) eingreifen.

8. Verbund-Bauteil nach einem der vorhergehenden Ansprüche, bei dem das Trägerteil (1) den Gehäusekörper (27) übergreift oder bei dem das optische Element (14) über den Gehäusekörper (27) gestülpt ist.

9. Verbund-Bauteil nach einem der vorhergehenden Ansprüche, bei dem das Trägerteil (1) den Gehäusekörper (27) lateral umläuft.

10. Verbund-Bauteil nach einem der vorhergehenden Ansprüche, bei dem das optische Element (14) von außerhalb des Gehäusekörpers (27) an einer den Gehäusekörper (27) lateral begrenzenden Seitenfläche (39,41,42,43) befestigt ist.

11. Verbund-Bauteil nach einem der vorhergehenden Ansprüche,
bei dem das optische Element (14) mittels eines Haftvermittlers (38) am optoelektronischen Bauelement (26) befestigt ist.

12. Verbund-Bauteil nach Anspruch 11,
bei dem der Haftvermittler (38) zwischen dem Trägerteil (1) und der Seitenfläche (39,41,42,43) des Gehäusekörpers angeordnet ist.

13. Verbund-Bauteil nach einem der Ansprüche 11 oder 12,
bei dem sich der Haftvermittler (38) entlang einer dem Strahlformungsteil (12) zugewandten Oberfläche des Gehäusekörpers erstreckt und von dieser Oberfläche ausgehend bis zur und entlang der Seitenfläche (39,41,42,43) erstreckt.

14. Verbund-Bauteil nach einem der Ansprüche 11 bis 13,
bei dem sich der Haftvermittler (38) von der Strahlungsdurchtrittsfläche des Gehäusekörpers (27) ausgehend bis zur und entlang der Seitenfläche (39,41,42,43) erstreckt.

15. Verbund-Bauteil nach mindestens Anspruch 4,
das zur bleifreien Lötmontage vorgesehen ist und das bei einer Temperatur von 250 °C oder größer über eine Dauer von wenigstens 10 s formstabil ist.

## Claims

1. A composite unit having an optoelectronic component (26) and an optical element (14) attached to this component, said optical element having a support part (1) and a beam shaping part (12), the beam shaping part being moulded onto the support part, **characterised in that** the optical element (14) is produced using a multicomponent casting method in which the support part (1) and the beam shaping part (12) are produced in a common mould, the beam shaping part (12) contains a silicone hybrid material with a silicone and an epoxy resin, and at least one connecting element (7a, 7b, 7c) is formed on or in the support part (1), a moulding composition moulded onto the support part (1) for the beam shaping part (12) being wholly or partially cured after moulding on and moulded onto the connecting element (7a, 7b, 7c), a mechanically stable connection being formed between the support part (1) and the beam shaping part (12), and the beam shaping part (12) being under tensile stress after curing.

2. A composite unit according to claim 1, in which the optical element (14) takes the form of an add-on optical system for placing on the optoelectronic component (26) or in which the optical element (14) is attached to the housing body (26) by means of the support part (1).

3. A composite unit according to any one of the preceding claims, in which the optoelectronic component (26) comprises a housing body (27) with a radiation passage face and the optical element (14) is attached to the housing body.

4. A composite unit according to any one of the preceding claims, in which the beam shaping part (12) is lenticular and the support part (1) is formed of a thermoplastics material or a thermoset.

5. A composite unit according to any one of the preceding claims, in which the support part (1) is made of a material which is opaque with regard to radiation to be received and/or generated in the optoelectronic component (26).

6. A composite unit according to any one of the preceding claims, in which the beam shaping part (12) is moulded through the connecting element (7a, 7b, 7c) in the manner of a rivet.

7. A composite unit according to any one of the preceding claims, in which one or a plurality of fastening elements (11) is/are formed on or in the support part (1), the optoelectronic component (26) comprising one or a plurality of mounting devices (46) corresponding to the fastening elements, in which the fastening elements engage to fasten the optical element (14) to the optoelectronic component (26).

8. A composite unit according to any one of the preceding claims, in which the support part (1) engages over the housing body (27) or in which the optical element (14) is drawn over the housing body (27).

9. A composite unit according to any one of the preceding claims, in which the support part (1) laterally surrounds the housing body (27).

10. A composite unit according to any one of the preceding claims, in which the optical element (14) is fastened from outside the housing body (27) to a side face (39, 41, 42, 43) laterally defining the housing body (27).

11. A composite unit according to any one of the preceding claims, in which the optical element (14) is fastened to the optoelectronic component (26) by means of a coupling agent (38).

12. A composite unit according to claim 11, in which the coupling agent (38) is arranged between the support part (1) and the side face (39, 41, 42, 43) of the housing body.

13. A composite unit according to either one of claims 11 or 12, in which the coupling agent (38) extends along a surface of the housing body facing the beam shaping part (12) and, from this surface, extends up to and along the side face (39, 41, 42, 43).

14. A composite unit according to any one of claims 11 to 13, in which the coupling agent (38) extends from the radiation passage face of the housing body (27) up to and along the side face (39, 41, 42, 43).

15. A composite unit according to at least claim 4, which is provided for lead-free solder mounting and which is dimensionally stable at a temperature of 250 °C or higher for a period of at least 10 s.

## Revendications

1. Elément composite comprenant un composant optoélectronique (26) et un élément optique (14) fixé sur celui-là, comprenant une pièce porteuse (1) et une pièce de formation de rayon (12), dans lequel la pièce de formation de rayon est formée sur la pièce porteuse,
**caractérisé en ce,**
**que** l'élément optique (14) est fabriqué au moyen d'un procédé de moulage à plusieurs composants et dans lequel la pièce porteuse (1) et la pièce de formation de rayon (12) sont fabriquées dans un moule commun, dans lequel la pièce de formation de rayon (12) contient une matière hybride en silicone comprenant un silicone et une résine époxydique, et en ce qu'au moins un élément de liaison (7a, 7b, 7c) est réalisé sur ou dans la pièce porteuse (1), une masse de moulage formée sur la pièce porteuse (1) pour la pièce de formation de rayon (12) étant durcie après la mise en forme et étant formée sur l'élément de liaison (7a, 7b, 7c), une liaison stable du point de vue mécanique étant réalisée entre la pièce porteuse (1) et la pièce de formation de rayon (12), la pièce de formation de rayon (12) étant sous contrainte de traction après le durcissement.

2. Elément composite selon la revendication 1,
dans lequel l'élément optique (14) est réalisé en tant qu'optique rapportée destinée à être posée sur le composant optoélectronique (26) ou dans lequel l'élément optique (14) est fixé sur le corps de boîtier (26) au moyen de la pièce porteuse (1).

3. Elément composite selon l'une quelconque des revendications précédentes,
dans lequel le composant optoélectronique (26) présente un corps de boîtier (27) doté d'une surface de traversée de rayonnement et dans lequel l'élément optique (14) est fixé sur le corps de boîtier.

4. Elément composite selon l'une quelconque des revendications précédentes,
dans lequel la pièce de formation de rayon (12) est réalisée en forme de lentille et la pièce porteuse (1) est formée à l'aide d'une matière thermoplastique ou d'une matière thermodurcissable.

5. Elément composite selon l'une quelconque des revendications précédentes,
dans lequel la pièce porteuse (1) est fabriquée dans une matière imperméable au rayonnement pour un rayonnement à recevoir et/ou à générer dans le composant optoélectronique (26).

6. Elément composite selon l'une quelconque des revendications précédentes,
dans lequel la pièce de formation de rayon (12) est formée à travers l'élément de liaison (7a,7b,7c) de manière semblable à des rivets.

7. Elément composite selon l'une quelconque des revendications précédentes,
dans lequel un ou une pluralité d'éléments de fixation (11) est réalisée sur ou dans la pièce porteuse (1), le composant optoélectronique (26) présentant un ou une pluralité de dispositifs de montage (46) correspondant aux éléments de fixation, dans lesquels dispositifs de montage ont prise les éléments de fixation pour la fixation de l'élément optique (14) sur le composant optoélectronique (26).

8. Elément composite selon l'une quelconque des revendications précédentes,
dans lequel la pièce porteuse (1) a prise par dessus le corps de boîtier (27) ou dans lequel l'élément optique (14) est retourné par dessus le corps de boîtier (27).

9. Elément composite selon l'une quelconque des revendications précédentes,
dans lequel la pièce porteuse (1) entoure le corps de boîtier (27) latéralement.

10. Elément composite selon l'une quelconque des revendications précédentes,
dans lequel l'élément optique (14) est fixé depuis l'extérieur du corps de boîtier (27) sur une surface latérale (39, 41, 42, 43) délimitant latéralement le corps de boîtier (27).

11. Elément composite selon l'une quelconque des revendications précédentes,
dans lequel l'élément optique (14) est fixé sur le composant optoélectronique (26) au moyen d'un agent adhésif (38).

12. Elément composite selon la revendication 11,
dans lequel l'agent adhésif (38) est disposé entre la pièce porteuse (1) et la surface latérale (39,41,42,43) du corps de boîtier.

13. Elément composite selon l'une quelconque des revendications 11 ou 12,
dans lequel l'agent adhésif (38) s'étend le long d'une surface du corps de boîtier, tournée vers la pièce de formation de rayon (12), et, partant de cette surface, s'étend jusqu'à et le long de la surface latérale (39,41,42,43).

14. Elément composite selon l'une quelconque des revendications 11 à 13,
dans lequel l'agent adhésif (38) s'étend en partant de la surface de traversée de rayonnement du corps de boîtier (27) jusqu'à et le long de la surface latérale (39,41,42,43).

15. Elément composite selon au moins la revendication 4, lequel est ménagé pour le montage soudé sans plomb et lequel, à une température de 250° C ou plus, est indéformable pendant une durée d'au moins 10 s.
